# EUROPEAN PATENT SPECIFICATION

(11) **EP 4 012 769 B1**
(45) Date of publication and mention of the grant of the patent: **31.12.2025**
(21) Application number: 19940436.9
(22) Date of filing: 07.08.2019
(51) Int. Cl.: H01L 23/00, H01L 21/683, H01L 23/544, H10H 29/02, H10H 29/03, H10H 29/30, H01L 21/67

(54) **METHOD FOR MANUFACTURING DISPLAY DEVICE, AND SUBSTRATE FOR MANUFACTURE OF DISPLAY DEVICE**
HERSTELLUNGSVERFAHREN EINER ANZEIGEVORRICHTUNG UND SUBSTRAT ZUR HERSTELLUNG EINER ANZEIGEVORRICHTUNG
PROCÉDÉ DE FABRICATION DE DISPOSITIF D'AFFICHAGE ET SUBSTRAT POUR FABRICATION DE DISPOSITIF D'AFFICHAGE

(30) Priority: 06.08.2019 KR 20190095606
(43) Date of publication of application: 15.06.2022
(73) Proprietor: LG Electronics Inc., SEOUL 07336 (KR)
(72) Inventor: KIM, Jungsub, Seoul 06772 (KR); KIM, Yongdae, Seoul 06772 (KR); KIM, Yoonchul, Seoul 06772 (KR); PARK, Changseo, Seoul 06772 (KR); JEON, Jina, Seoul 06772 (KR)
(74) Representative: Vossius & Partner Patentanwälte Rechtsanwälte mbB
(86) International application number: PCT/KR2019/009862
(87) International publication number: WO 2021/025202

(56) References cited:
- WO-A1-2017/178364
- KR-A- 20050 069 938
- KR-A- 20170 059 068
- KR-A- 20180 003 246
- KR-A- 20180 120 527
- KR-A- 20180 120 527
- KR-A- 20190 085 892
- KR-B1- 100 685 913
- KR-B1- 101 941 541
- US-A1- 2017 062 515
- US-A1- 2018 182 940
- US-A1- 2018 190 672

## Description

### [Technical Field]

The present disclosure relates to technology related to a display device, and more particularly to a method for manufacturing a display device using a micro-light emitting diode (micro-LED) and a substrate used in manufacturing the display device.

### [Background Art]

KR 2019 0085892 (A) relates to a micro LED display device assembled in an assembly hole having an assembly electrode capable of forming a non-uniform electric field and a method for manufacturing the same.

US 2017/062515 A1 discloses a light-emitting diode structure including a separation unit between light-emitting diode units.

US 2018/182940 A1 discloses a light emitting device including a mounting board, light sources, a light diffuser, a wavelength conversion layer, and scatter reflection portions.

KR 2018 0003246 A discloses a display device including a substrate on which wiring electrodes are formed, a plurality of semiconductor light emitting elements electrically connected to the wiring electrodes, a plurality of phosphor layers for converting wavelength of light, and a plurality of filtering units for filtering blue, green, and red light.

Recently, in the field of display technology, a display device having excellent characteristics in terms of thinness and flexibility has been developed. On the other hand, currently commercialized major displays are represented by a liquid crystal display (LCD) and organic light emitting diodes (OLED).

However, in the case of the LCD, the response time is not sufficiently short and it is difficult to implement a flexible display. In the case of the OLED, the lifespan of the OLED is short and the mass production yield thereof is not good.

A light emitting diode (LED) is a light emitting semiconductor device that is well known for converting electric current into light. Red LEDs using GaAsP compound semiconductors began to be commercialized in 1962, and have been used as light sources along with GaP:N-based green LEDs for image display on electronic devices including information and communication devices. Accordingly, one solution to the above-described issues may be to implement a display using the light emitting semiconductor device. The light emitting semiconductor device has various advantages, such as a long lifespan, low power consumption, excellent characteristics related to initial driving, and high resistance against vibration, compared to a filament-based light emitting device.

However, in order to implement a large-area high-resolution display device using semiconductor light emitting diodes (LEDs), a very large number of semiconductor LEDs should be accurately assembled with or transferred to a wiring substrate of the display device.

Accordingly, the present disclosure provides a method for manufacturing a display device in which semiconductor LEDs are transferred onto the wiring substrate with a minimum number of alignment errors, and a substrate used in manufacturing the display device.

### [Disclosure]

### [Technical Problem]

An object of the present disclosure is to provide a method for manufacturing a display device having high reliability using semiconductor LEDs.

Another object of the present disclosure is to provide an assembly substrate and a wiring substrate capable of minimizing alignment errors during a transfer process in which semiconductor LEDs are transferred to manufacture a large-area display device.

Further, another object of the present disclosure is to solve various problems not mentioned herein. Those skilled in the art will appreciate the embodiments of the present disclosure through the description and drawings to be described later.

### [Technical Solutions]

According to the invention, there is disclosed a method for manufacturing a display device as recited in claim 1.

The lighting semiconductor LED and the alignment semiconductor LED may be semiconductor LEDs having a same structure formed by a same fabrication process.

The assembling the semiconductor LED into the first assembly groove or the second assembly groove may include introducing the semiconductor LEDs into a fluid chamber; disposing the assembly substrate at an upper surface of the fluid chamber; allowing the semiconductor LEDs floating in the fluid chamber to be in contact with the first assembly groove or the second assembly groove of the assembly substrate using an assembly device having a magnetic material; and assembling the semiconductor LEDs into the first assembly groove or the second assembly groove based on an electric field received through an assembly electrode formed in the assembly substrate.

The transfer substrate may include a plurality of protrusions formed not only at a position corresponding to the lighting semiconductor LED assembled into the assembly substrate, but also at a position corresponding to the alignment semiconductor LED. The transferring the semiconductor LEDs assembled into the assembly substrate from the transfer substrate to the transfer substrate may include overlapping the assembly substrate and the transfer substrate in a manner that the protrusions and the semiconductor LEDs overlap each other; allowing the overlapped semiconductor LEDs to contact the protrusions so that the semiconductor LEDs are fixed; and removing the assembly substrate.

The assembly substrate and the transfer substrate may be provided with alignment keys having the same uneven structure for alignment at positions where the assembly substrate and the transfer substrate are arranged to correspond to each other.

The transferring the semiconductor LEDs assembled into the assembly substrate may include overlapping the alignment keys formed at the positions where the assembly substrate and the transfer substrate are arranged to correspond to each other.

The transferring the semiconductor LEDs transferred onto the transfer substrate from the transfer substrate to the wiring substrate may include aligning the transfer substrate and the wiring substrate in manner that the semiconductor LEDs are disposed in a partial region corresponding to the semiconductor LEDs transferred onto the transfer substrate, from among an entire region of the wiring substrate; and fixing the semiconductor LEDs to a region corresponding to the semiconductor LEDs of the wiring substrate, and removing the transfer substrate.

The wiring substrate may be formed of light transmissive material, and the aligning of the transfer substrate and the wiring substrate may be performed using an image photographed by a camera disposed at a back surface of the wiring substrate.

The aligning of the transfer substrate and the wiring substrate may include overlapping a region corresponding to the semiconductor LEDs of the transfer substrate and a region corresponding to the semiconductor LEDs of the wiring substrate, using the image photographed by the camera.

The transfer substrate and the wiring substrate are provided with alignment keys having a same uneven structure for alignment at positions where the transfer substrate and the wiring substrate are arranged to correspond to each other.

The aligning the transfer substrate and the wiring substrate includes a first alignment step in which the alignment keys formed at the positions corresponding to each other in the transfer substrate and the wiring substrate are disposed to overlap each other; and a second alignment step in which the alignment semiconductor LED transferred onto the transfer substrate is disposed to overlap an alignment mark of the wiring substrate formed at a position corresponding to the alignment semiconductor LED.

The method may further include: after transferring the semiconductor LED onto the wiring substrate, performing a wiring process in a manner that the lighting semiconductor LED is electrically connected to the wiring substrate.

The method may further include: applying a material having low light transmittance at an upper portion of the alignment semiconductor LED.

The assembly substrate may include a first assembly substrate assembled with the first semiconductor LED emitting first color light, when the display device is driven; and a second assembly substrate assembled with the second semiconductor LED emitting second color light different from the first color light.

According to a further aspect of the invention, there is disclosed a display device as recited in claim 12.

The number of the lighting semiconductor LEDs for each unit area within the wiring substrate is at least 100 times larger than the number of the alignment semiconductor LEDs for each unit area within the wiring substrate.

The wiring substrate further includes an alignment key having an uneven structure.

The semiconductor LED may be a micro-LED having a size of a micrometer (µm) unit.

### [Advantageous Effects]

As is apparent from the above description, the embodiments of the present disclosure can provide a new method for manufacturing a high-reliability display device using semiconductor LEDs.

Specifically, when the semiconductor LEDs are self-assembled with an assembly substrate using an electromagnetic field, an assembly groove assembled with the semiconductor LEDs for alignment may be formed in the assembly substrate. In this case, the alignment semiconductor LED assembled in the assembly groove may be used for alignment in a step of transferring the semiconductor LEDs to the final wiring substrate. Unlike the legacy alignment key, the alignment semiconductor LED is designed in a manner that alignment errors of the semiconductor LEDs can be reflected in the transfer process after assembly. As a result, the semiconductor LEDs are transferred to the wiring substrate based on the alignment semiconductor LED, thereby increasing transfer accuracy.

Further, according to another embodiment of the present disclosure, there are additional technical effects not mentioned here. Those skilled in the art can understand the present disclosure through the purposes of the specification and drawings.

### [Description of Drawings]

FIG. 1 is a conceptual view illustrating an embodiment of a display device using a light emitting semiconductor device according to the present disclosure;
FIG. 2 is a partially enlarged view showing part A of FIG. 1;
FIGS. 3A and 3B are cross-sectional views taken along lines B-B and C-C in FIG. 2;
FIG. 4 is a conceptual view illustrating the flip-chip type light emitting semiconductor device of FIG. 3;
FIGS. 5A to 5C are conceptual views illustrating various examples of implementation of colors in relation to a flip-chip type light emitting semiconductor device.
FIG. 6 is a flowchart illustrating a method for manufacturing a display device including semiconductor light emitting devices (LEDs) respectively emitting red light (R), green light (G), and blue light (B).
FIG. 7 is a flowchart illustrating a method for assembling semiconductor LEDs into a substrate according to a self-assembly method.
FIG. 8 is an enlarged view illustrating a specific portion (D) of FIG. 7.
FIG. 9 is a flowchart illustrating a process in which a lighting semiconductor LED and an alignment semiconductor LED are assembled with each other according to the self-assembly method.
FIG. 10 is a cross-sectional view illustrating a structure in which a lighting semiconductor LED and an alignment semiconductor LED are assembled into an assembly substrate according to the self-assembly method.
FIG. 11 is a cross-sectional view illustrating a method for manufacturing a display device using an assembly substrate and a wiring substrate.
FIG. 12 is a plan view illustrating an assembly substrate and semiconductor LEDs assembled into the assembly substrate according to the present disclosure.
FIG. 13 is a plan view illustrating a transfer substrate and semiconductor LEDs transferred to the transfer substrate according to the present disclosure.
FIG. 14 is a plan view illustrating a wiring substrate and semiconductor LEDs transferred to the wiring substrate according to the present disclosure.
FIG. 15 is a plan view illustrating semiconductor LEDs transferred only in a partial region of the wiring substrate.
FIG. 16 is a plan view illustrating the wiring substrate after completion of a wiring process that is performed on the semiconductor LEDs transferred to the wiring substrate.

### [Best Mode]

Reference will now be made in detail to embodiments of the present disclosure, examples of which are illustrated in the accompanying drawings. Wherever possible, the same reference numbers will be used throughout the drawings to refer to the same or like parts, and redundant description thereof will be omitted. As used herein, the suffixes "module" and "unit" are added or used interchangeably to facilitate preparation of this specification and are not intended to suggest distinct meanings or functions. In describing embodiments disclosed in this specification, relevant well-known technologies may not be described in detail in order not to obscure the subject matter of the embodiments disclosed in this specification.

Furthermore, although the drawings are separately described for simplicity, embodiments implemented by combining at least two or more drawings are also within the scope of the present disclosure.

In addition, when an element such as a layer, region or module is described as being "on" another element, it is to be understood that the element may be directly on the other element or there may be an intermediate element between them.

The display device described herein is a concept including all display devices that display information with a unit pixel or a set of unit pixels. Therefore, the display device may be applied not only to finished products but also to parts. For example, a panel corresponding to a part of a digital TV also independently corresponds to the display device in the present specification. The finished products include a mobile phone, a smartphone, a laptop, a digital broadcasting terminal, a personal digital assistant (PDA), a portable multimedia player (PMP), a navigation system, a slate PC, a tablet, an Ultrabook, a digital TV, a desktop computer, and the like.

However, it will be readily apparent to those skilled in the art that the configuration according to the embodiments described herein is applicable even to a new product that will be developed later as a display device.

In addition, the light emitting semiconductor device mentioned in this specification is a concept including an LED, a micro LED, and the like, and may be used interchangeably therewith.

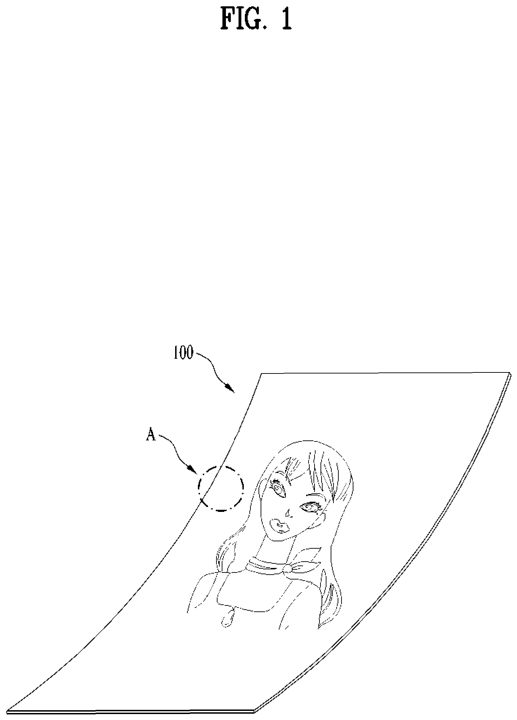

FIG. 1 is a conceptual view illustrating an embodiment of a display device using a light emitting semiconductor device according to the present disclosure.

As shown in FIG. 1, information processed by a controller (not shown) of a display device 100 may be displayed using a flexible display.

The flexible display may include, for example, a display that can be warped, bent, twisted, folded, or rolled by external force.

Furthermore, the flexible display may be, for example, a display manufactured on a thin and flexible substrate that can be warped, bent, folded, or rolled like paper while maintaining the display characteristics of a conventional flat panel display.

When the flexible display remains in an unbent state (e.g., a state having an infinite radius of curvature) (hereinafter referred to as a first state), the display area of the flexible display forms a flat surface. When the display in the first state is changed to a bent state (e.g., a state having a finite radius of curvature) (hereinafter referred to as a second state) by external force, the display area may be a curved surface. As shown in FIG. 1, the information displayed in the second state may be visual information output on a curved surface. Such visual information may be implemented by independently controlling the light emission of sub-pixels arranged in a matrix form. The unit pixel may mean, for example, a minimum unit for implementing one color.

The unit pixel of the flexible display may be implemented by a light emitting semiconductor device. In the present disclosure, a light emitting diode (LED) is exemplified as a type of the light emitting semiconductor device configured to convert electric current into light. The LED may be formed in a small size, and may thus serve as a unit pixel even in the second state.

Hereinafter, a flexible display implemented using the LED will be described in more detail with reference to the drawings.

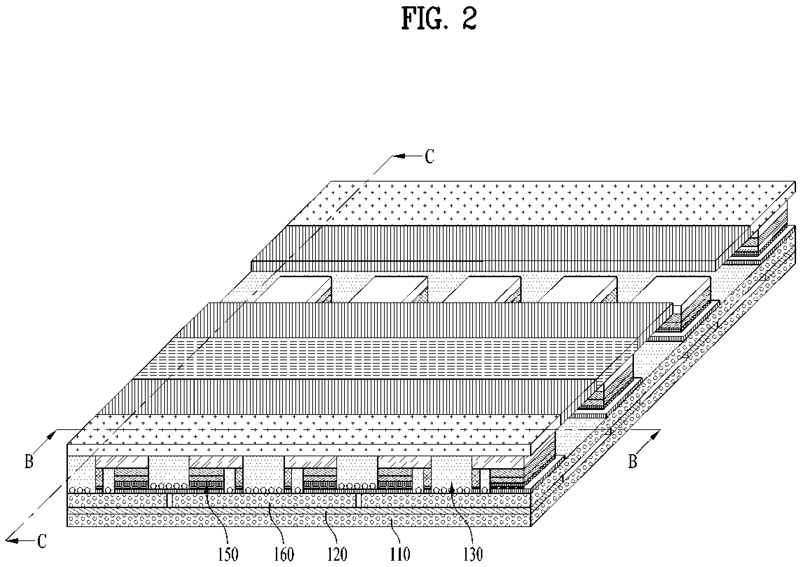

FIG. 2 is a partially enlarged view showing part A of FIG. 1;

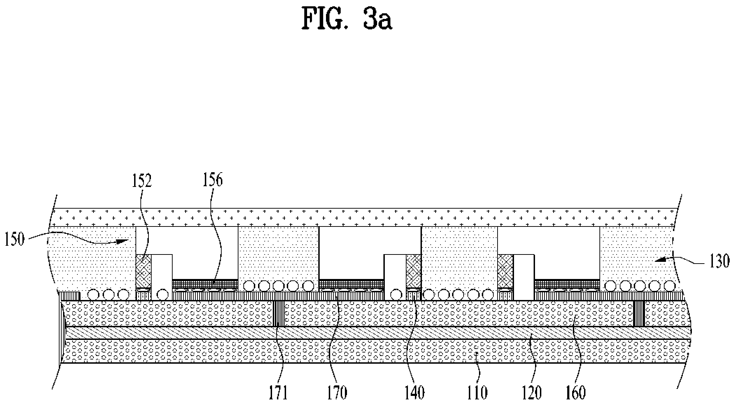

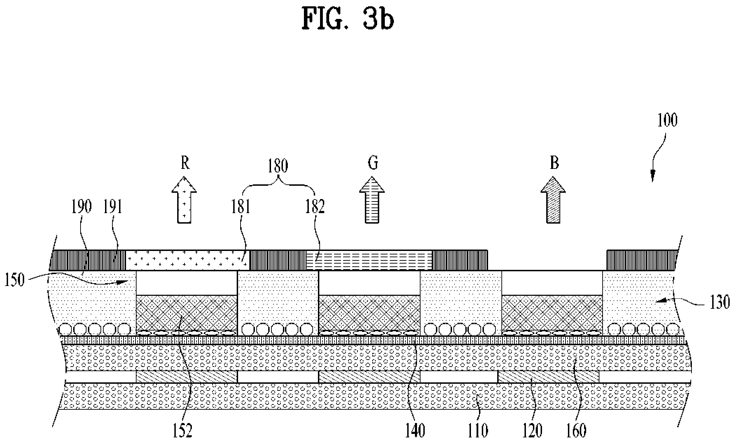

FIGS. 3A and 3B are cross-sectional views taken along lines B-B and C-C in FIG. 2.

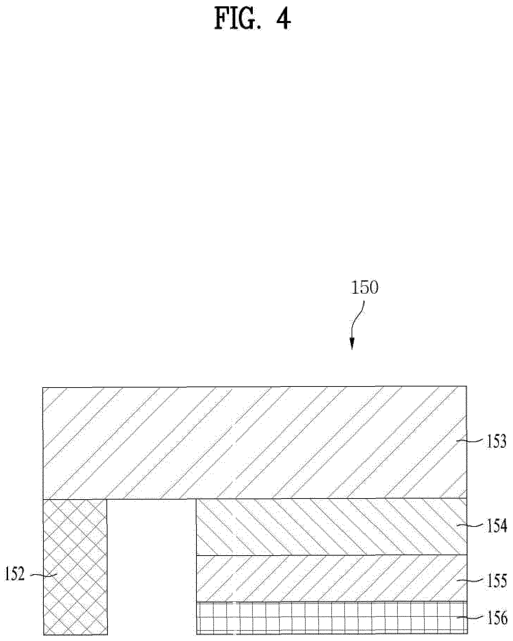

FIG. 4 is a conceptual view illustrating the flip-chip type light emitting semiconductor device of FIG. 3.

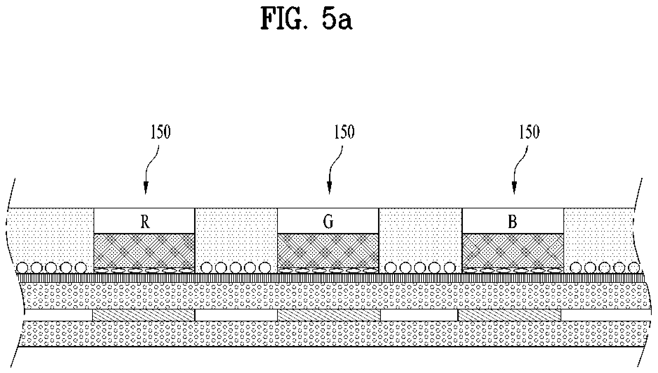

FIGS. 5A to 5C are conceptual views illustrating various examples of implementation of colors in relation to a flip-chip type light emitting semiconductor device.

As shown in FIGS. 2, 3A and 3B , the display device 100 using a passive matrix (PM) type light emitting semiconductor device is exemplified as the display device 100 using a light emitting semiconductor device. However, the examples described below are also applicable to an active matrix (AM) type light emitting semiconductor device.

The display device 100 shown in FIG. 1 may include a substrate 110, a first electrode 120, a conductive adhesive layer 130, a second electrode 140, and at least one light emitting semiconductor device 150, as shown in FIG. 2.

The substrate 110 may be a flexible substrate. For example, to implement a flexible display device, the substrate 110 may include glass or polyimide (PI). Any insulative and flexible material such as polyethylene naphthalate (PEN) or polyethylene terephthalate (PET) may be employed. In addition, the substrate 110 may be formed of either a transparent material or an opaque material.

The substrate 110 may be a wiring substrate on which the first electrode 120 is disposed. Thus, the first electrode 120 may be positioned on the substrate 110.

As shown in FIG. 3A, an insulating layer 160 may be disposed on the substrate 110 on which the first electrode 120 is positioned, and an auxiliary electrode 170 may be positioned on the insulating layer 160. In this case, a stack in which the insulating layer 160 is laminated on the substrate 110 may be a single wiring substrate. More specifically, the insulating layer 160 may be formed of an insulative and flexible material such as PI, PET, or PEN, and may be integrated with the substrate 110 to form a single substrate.

The auxiliary electrode 170, which is an electrode that electrically connects the first electrode 120 and the light emitting semiconductor device 150, is positioned on the insulating layer 160, and is disposed to correspond to the position of the first electrode 120. For example, the auxiliary electrode 170 may have a dot shape and may be electrically connected to the first electrode 120 by an electrode hole 171 formed through the insulating layer 160. The electrode hole 171 may be formed by filling a via hole with a conductive material.

As shown in FIGS. 2 or 3A, a conductive adhesive layer 130 may be formed on one surface of the insulating layer 160, but embodiments of the present disclosure are not limited thereto. For example, a layer performing a specific function may be formed between the insulating layer 160 and the conductive adhesive layer 130, or the conductive adhesive layer 130 may be disposed on the substrate 110 without the insulating layer 160. In a structure in which the conductive adhesive layer 130 is disposed on the substrate 110, the conductive adhesive layer 130 may serve as an insulating layer.

The conductive adhesive layer 130 may be a layer having adhesiveness and conductivity. For this purpose, a material having conductivity and a material having adhesiveness may be mixed in the conductive adhesive layer 130. In addition, the conductive adhesive layer 130 may have ductility, thereby providing making the display device flexible.

As an example, the conductive adhesive layer 130 may be an anisotropic conductive film (ACF), an anisotropic conductive paste, a solution containing conductive particles, or the like. The conductive adhesive layer 130 may be configured as a layer that allows electrical interconnection in the direction of the Z-axis extending through the thickness, but is electrically insulative in the horizontal X-Y direction. Accordingly, the conductive adhesive layer 130 may be referred to as a Z-axis conductive layer (hereinafter, referred to simply as a "conductive adhesive layer").

The ACF is a film in which an anisotropic conductive medium is mixed with an insulating base member. When the ACF is subjected to heat and pressure, only a specific portion thereof becomes conductive by the anisotropic conductive medium. Hereinafter, it will be described that heat and pressure are applied to the ACF. However, another method may be used to make the ACF partially conductive. The other method may be, for example, application of only one of the heat and pressure or UV curing.

In addition, the anisotropic conductive medium may be, for example, conductive balls or conductive particles. For example, the ACF may be a film in which conductive balls are mixed with an insulating base member. Thus, when heat and pressure are applied to the ACF, only a specific portion of the ACF is allowed to be conductive by the conductive balls. The ACF may contain a plurality of particles formed by coating the core of a conductive material with an insulating film made of a polymer material. In this case, as the insulating film is destroyed in a portion to which heat and pressure are applied, the portion is made to be conductive by the core. At this time, the cores may be deformed to form layers that contact each other in the thickness direction of the film. As a more specific example, heat and pressure are applied to the whole ACF, and an electrical connection in the Z-axis direction is partially formed by the height difference of a counterpart adhered by the ACF.

As another example, the ACF may contain a plurality of particles formed by coating an insulating core with a conductive material. In this case, as the conductive material is deformed (pressed) in a portion to which heat and pressure are applied, the portion is made to be conductive in the thickness direction of the film. As another example, the conductive material may be disposed through the insulating base member in the Z-axis direction to provide conductivity in the thickness direction of the film. In this case, the conductive material may have a pointed end.

The ACF may be a fixed array ACF in which conductive balls are inserted into one surface of the insulating base member. More specifically, the insulating base member may be formed of an adhesive material, and the conductive balls may be intensively disposed on the bottom portion of the insulating base member. Thus, when the base member is subjected to heat and pressure, it may be deformed together with the conductive balls, exhibiting conductivity in the vertical direction.

However, the present disclosure is not necessarily limited thereto, and the ACF may be formed by randomly mixing conductive balls in the insulating base member, or may be composed of a plurality of layers with conductive balls arranged on one of the layers (as a double- ACF).

The anisotropic conductive paste may be a combination of a paste and conductive balls, and may be a paste in which conductive balls are mixed with an insulating and adhesive base material. Also, the solution containing conductive particles may be a solution containing any conductive particles or nanoparticles.

Referring back to FIG. 3A, the second electrode 140 is positioned on the insulating layer 160 and spaced apart from the auxiliary electrode 170. That is, the conductive adhesive layer 130 is disposed on the insulating layer 160 having the auxiliary electrode 170 and the second electrode 140 positioned thereon.

After the conductive adhesive layer 130 is formed with the auxiliary electrode 170 and the second electrode 140 positioned on the insulating layer 160, the light emitting semiconductor device 150 is connected thereto in a flip-chip form by applying heat and pressure. Thereby, the light emitting semiconductor device 150 is electrically connected to the first electrode 120 and the second electrode 140.

Referring to FIG. 4, the light emitting semiconductor device may be a flip chip-type light emitting device.

For example, the light emitting semiconductor device may include a p-type electrode 156, a p-type semiconductor layer 155 on which the p-type electrode 156 is formed, an active layer 154 formed on the p-type semiconductor layer 155, an n-type semiconductor layer 153 formed on the active layer 154, and an n-type electrode 152 disposed on the n-type semiconductor layer 153 and horizontally spaced apart from the p-type electrode 156. In this case, the p-type electrode 156 may be electrically connected to the auxiliary electrode 170, which is shown in FIG. 3, by the conductive adhesive layer 130, and the n-type electrode 152 may be electrically connected to the second electrode 140.

Referring back to FIGS. 2, 3A and 3B, the auxiliary electrode 170 may be elongated in one direction. Thus, one auxiliary electrode may be electrically connected to the plurality of light emitting semiconductor devices 150. For example, p-type electrodes of light emitting semiconductor devices on left and right sides of an auxiliary electrode may be electrically connected to one auxiliary electrode.

More specifically, the light emitting semiconductor device 150 may be press-fitted into the conductive adhesive layer 130 by heat and pressure. Thereby, only the portions of the light emitting semiconductor device 150 between the p-type electrode 156 and the auxiliary electrode 170 and between the n-type electrode 152 and the second electrode 140 may exhibit conductivity, and the other portions of the light emitting semiconductor device 150 do not exhibit conductivity as they are not press-fitted. In this way, the conductive adhesive layer 130 interconnects and electrically connects the light emitting semiconductor device 150 and the auxiliary electrode 170 and interconnects and electrically connects the light emitting semiconductor device 150 and the second electrode 140.

The plurality of light emitting semiconductor devices 150 may constitute a light emitting device array, and a phosphor conversion layer 180 may be formed on the light emitting device array.

The light emitting device array may include a plurality of light emitting semiconductor devices having different luminance values. Each light emitting semiconductor device 150 may constitute a unit pixel and may be electrically connected to the first electrode 120. For example, a plurality of first electrodes 120 may be provided, and the light emitting semiconductor devices may be arranged in, for example, several columns. The light emitting semiconductor devices in each column may be electrically connected to any one of the plurality of first electrodes.

In addition, since the light emitting semiconductor devices are connected in a flip-chip form, light emitting semiconductor devices grown on a transparent dielectric substrate may be used. The light emitting semiconductor devices may be, for example, nitride light emitting semiconductor devices. Since the light emitting semiconductor device 150 has excellent luminance, it may constitute an individual unit pixel even when it has a small size.

As shown in FIG. 3, a partition wall 190 may be formed between the light emitting semiconductor devices 150. In this case, the partition wall 190 may serve to separate individual unit pixels from each other, and may be integrated with the conductive adhesive layer 130. For example, by inserting the light emitting semiconductor device 150 into the ACF, the base member of the ACF may form the partition wall.

In addition, when the base member of the ACF is black, the partition wall 190 may have reflectance and increase contrast even without a separate black insulator.

As another example, a reflective partition wall may be separately provided as the partition wall 190. In this case, the partition wall 190 may include a black or white insulator depending on the purpose of the display device. When a partition wall including a white insulator is used, reflectivity may be increased. When a partition wall including a black insulator is used, it may have reflectance and increase contrast.

The phosphor layer 180 may be positioned on the outer surface of the light emitting semiconductor device 150. For example, the light emitting semiconductor device 150 may be a blue light emitting semiconductor device that emits blue (B) light, and the phosphor conversion layer 180 may function to convert the blue (B) light into a color of a unit pixel. The phosphor conversion layer 180 may be a red phosphor 181 or a green phosphor 182 constituting an individual pixel.

That is, the red phosphor 181 capable of converting blue light into red (R) light may be laminated on a blue light emitting semiconductor device at a position of a unit pixel of red color, and the green phosphor 182 capable of converting blue light into green (G) light may be laminated on the blue light emitting semiconductor device at a position of a unit pixel of green color. Only the blue light emitting semiconductor device may be used alone in the portion constituting the unit pixel of blue color. In this case, unit pixels of red (R), green (G), and blue (B) may constitute one pixel. More specifically, a phosphor of one color may be laminated along each line of the first electrode 120. Accordingly, one line on the first electrode 120 may be an electrode for controlling one color. That is, red (R), green (G), and blue (B) may be sequentially disposed along the second electrode 140, thereby implementing a unit pixel.

However, embodiments of the present disclosure are not limited thereto. Unit pixels of red (R), green (G), and blue (B) may be implemented by combining the light emitting semiconductor device 150 and the quantum dot (QD) rather than using the phosphor.

Also, a black matrix 191 may be disposed between the phosphor conversion layers to improve contrast. That is, the black matrix 191 may improve contrast of light and darkness.

However, embodiments of the present disclosure are not limited thereto, and anther structure may be applied to implement blue, red, and green colors.

Referring to FIG. 5A, each light emitting semiconductor device 150 may be implemented as a high-power light emitting device emitting light of various colors including blue by using gallium nitride (GaN) as a main material and adding indium (In) and/or aluminum (Al).

In this case, each light emitting semiconductor device 150 may be a red, green, or blue light emitting semiconductor device to form a unit pixel (sub-pixel). For example, red, green, and blue light emitting semiconductor devices R, G, and B may be alternately disposed, and unit pixels of red, green, and blue may constitute one pixel by the red, green and blue light emitting semiconductor devices. Thereby, a full-color display may be implemented.

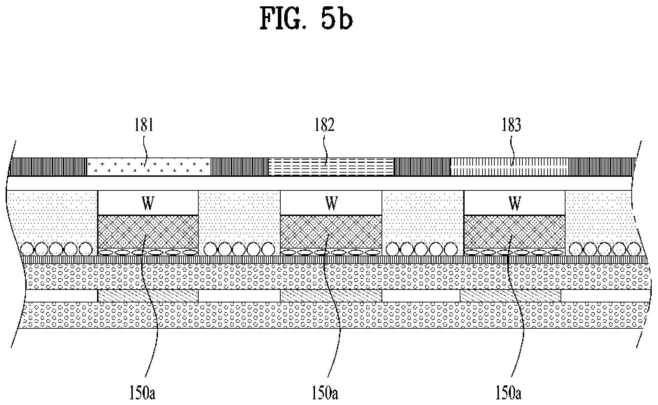

Referring to FIG. 5B, the light emitting semiconductor device 150a may include a white light emitting device W having a yellow phosphor conversion layer, which is provided for each device. In this case, in order to form a unit pixel, a red phosphor conversion layer 181, a green phosphor conversion layer 182, and a blue phosphor conversion layer 183 may be disposed on the white light emitting device W. In addition, a unit pixel may be formed using a color filter repeating red, green, and blue on the white light emitting device W.

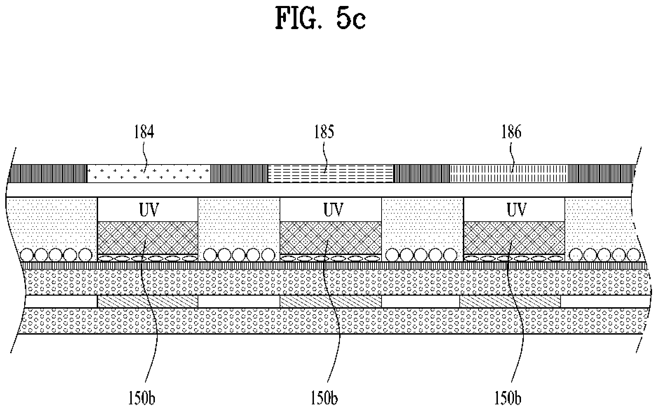

Referring to FIG. 5C, a red phosphor conversion layer 181, a green phosphor conversion layer 185, and a blue phosphor conversion layer 183 may be provided on a ultraviolet light emitting device. Not only visible light but also ultraviolet (UV) light may be used in the entire region of the light emitting semiconductor device. In an embodiment, UV may be used as an excitation source of the upper phosphor in the light emitting semiconductor device.

Referring back to this example, the light emitting semiconductor device is positioned on the conductive adhesive layer to constitute a unit pixel in the display device. Since the light emitting semiconductor device has excellent luminance, individual unit pixels may be configured despite even when the light emitting semiconductor device has a small size.

Regarding the size of such an individual light emitting semiconductor device, the length of each side of the device may be, for example, 80 µm or less, and the device may have a rectangular or square shape. When the light emitting semiconductor device has a rectangular shape, the size thereof may be less than or equal to 20 µm x 80 µm.

In addition, even when a square light emitting semiconductor device having a side length of 10 µm is used as a unit pixel, sufficient brightness to form a display device may be obtained.

Therefore, for example, when the unit pixel is a rectangular pixel having one side of 600 µm and the other side of 300 µm, the distance between the semiconductor LEDs is relatively large.

Therefore, in this case, a flexible display device implementing high-quality images higher than HD quality or greater can be implemented.

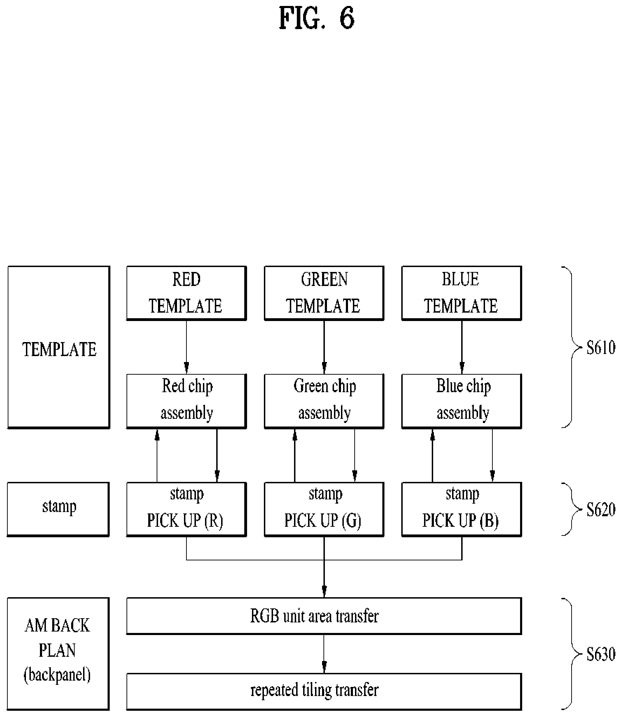

FIG. 6 is a flowchart illustrating a method for manufacturing a display device including semiconductor light emitting devices (LEDs) respectively emitting red light (R), green light (G), and blue light (B).

It is assumed that FIGS. 1 to 5 illustrate the display device after semiconductor LEDs are assembled into the wiring substrate. FIG. 6 is a flowchart illustrating a method for manufacturing the display device having only one unit pixel by transferring RGB sub-pixels.

Also, as shown in FIG. 6, in order to implement the display device according to the present disclosure, a step of transferring the semiconductor LEDs onto the assembly substrate and the transfer substrate is performed in advance so that the semiconductor LEDs can be disposed on the wiring substrate.

The step in which the semiconductor LEDs are assembled into the assembly substrate is performed by a self-assembly method using an electric field and a magnetic field, and as such a detailed description thereof will be given later.

In FIG. 6, a template may refer to an assembly substrate.

According to the manufacturing method shown in FIG. 6, three kinds of assembly substrates and three kinds of transfer substrates are required to manufacture the display device including a red chip, a green chip, and a blue chip.

Specifically, the assembly substrate may include a red assembly substrate to assemble the red semiconductor LED, a green assembly substrate to assemble the green semiconductor LED, and a blue assembly substrate to assemble the blue semiconductor LED.

In addition, the manufacturing method may be broadly classified into a first step S610 for assembling the semiconductor LEDs in the template, a second step S610 for transferring the semiconductor LEDs onto the transfer substrate such as a stamp, and a third step S630 for transferring the semiconductor LEDs onto the wiring substrate capable of being driven by active matrix.

First, the step S610 of assembling the semiconductor LED into the assembly substrate may include assembling semiconductor LEDs emitting different colors of light into the corresponding assembly substrates, respectively. For example, a first semiconductor LED emitting first color light may be assembled into a first assembly substrate, and a second semiconductor LED emitting second color light different from the first color light may be assembled into a second assembly substrate.

Thereafter, the semiconductor LEDs respectively assembled into the assembly substrates may be transferred onto different transfer substrates (S620). That is, the first semiconductor LED assembled into the first assembly substrate may be transferred onto the first transfer substrate, and the second semiconductor LED assembled into the second assembly substrate may be transferred onto the second transfer substrate.

Referring to FIG. 6, the transferring step S620 may include: transferring the red semiconductor LED from the red assembly substrate to the red transfer substrate (Stamp R) by compressing the red transfer substrate (Stamp R) onto the red assembly substrate; transferring the green semiconductor LED from the green assembly substrate to the green transfer substrate (Stamp G) by compressing the green transfer substrate (Stamp G) onto the green assembly substrate; and transferring the blue semiconductor LED from the blue assembly substrate to the blue transfer substrate (Stamp B) by compressing the blue transfer substrate (Stamp B) onto the blue assembly substrate.

Finally, the respective transfer substrates are compressed onto the wiring substrate, so that the red semiconductor LED, the green semiconductor LED, and the blue semiconductor LED are transferred onto the wiring substrate (S630).

In order to implement a large-area display device, the process of transferring the semiconductor LEDs from the transfer substrate to the wiring substrate may be performed multiple times. A tiling transfer action may be performed multiple times such that each of the transfer steps can be performed at a predetermined position of one wiring substrate.

In contrast, unlike the method shown in FIG. 6, three kinds of assembly substrates and only one transfer substrate may be used such that a first semiconductor LED corresponding to red, a second semiconductor LED corresponding to green, and a third semiconductor LED corresponding to blue may be transferred onto the wiring substrate as necessary.

For example, the step of transferring the semiconductor LEDs respectively assembled into three assembly substrates onto the wiring substrate may include transferring the semiconductor LEDs assembled into the assembly substrates onto only one transfer substrate (RGB integrated stamp); and transferring all three kinds of semiconductor LEDs onto the wiring substrate by compressing the transfer substrate with the wiring substrate.

In addition, only one kind of assembly substrate and only one kind of transfer substrate may also be used to transfer the semiconductor LEDs respectively corresponding to red, green and blue onto the wiring substrate. In this case, when self-assembly is performed, all semiconductor LEDs corresponding to red, green, and blue are assembled into one assembly substrate, and are collectively transferred onto the transfer substrate and the wiring substrate.

Meanwhile, the detailed steps included in each step shown in FIG. 6 can be partially deleted or modified without departing from the scope of the present disclosure, as will be appreciated by those skilled in the art.

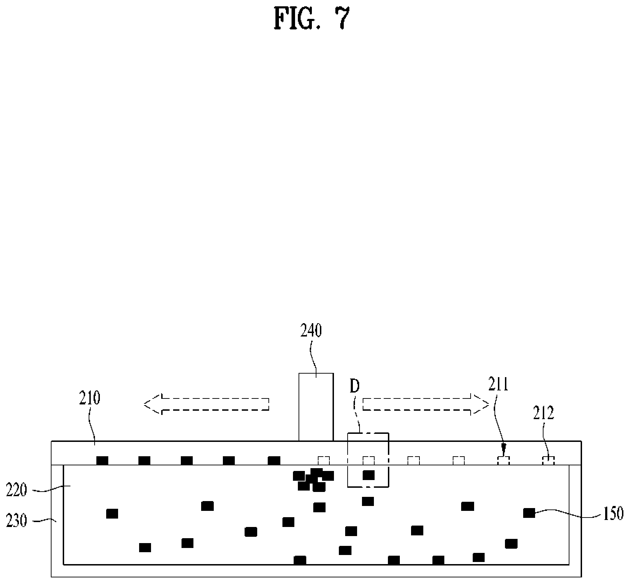

FIG. 7 is a flowchart illustrating a method for assembling semiconductor LEDs into the substrate according to a self-assembly method.

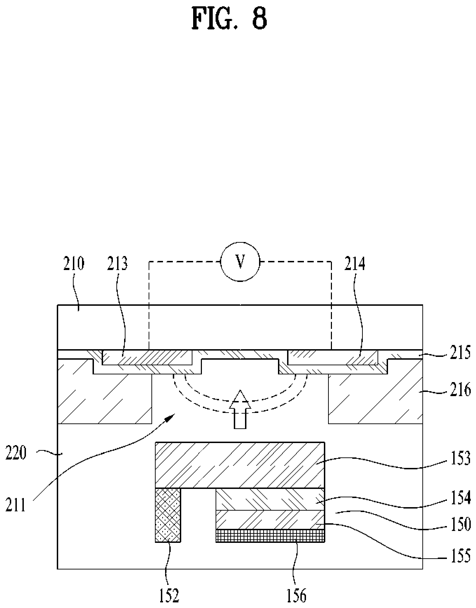

FIG. 8 is an enlarged view illustrating the portion (D) of FIG. 7.

FIGS. 7 and 8 illustrate examples in which the semiconductor LEDs are electromagnetically assembled into the substrate using the self-assembly method.

Referring to FIGS. 7 and 8, the semiconductor LEDs 150 may be introduced into a chamber 230 filled with fluid 220.

Thereafter, the assembly substrate 210 may be disposed on the chamber 230. According to one embodiment, the assembly substrate 210 may also be introduced into the chamber 230.

One pair of two electrodes 213 and 214 corresponding to the respective semiconductor LEDs 150 to be assembled may be formed in the assembly substrate 210. The electrodes 213 and 214 may be implemented as a transparent electrode such as indium tin oxide (ITO) or may also be formed of other general materials as needed. The electrodes 213 and 214 may generate an electric field upon receiving a voltage, and may be used as assembly electrodes capable of stably fixing the semiconductor LEDs 150 contacting the assembly grooves 211 and 212.

Specifically, an AC voltage may be applied to the electrodes 213 and 214, and each of the semiconductor LEDs 150 floating around the electrodes 213 and 214 may have a polarity by dielectric polarization. In addition, the dielectrically polarized semiconductor LED may be moved or fixed in a specific direction by a non-uniform electric field formed around the electrodes 213 and 214. This operation is referred to as dielectrophoresis. In the self-assembly process of the present disclosure, the semiconductor LEDs 150 can be stably fixed to the assembly grooves 211 and 212 using dielectrophoresis.

According to an aspect of the invention, the assembly grooves include a first assembly groove 211 for a lighting semiconductor LED and a second assembly groove 212 for a semiconductor LED for alignment (hereinafter referred to as an alignment semiconductor LED). The alignment assembly groove 212 is mainly used for alignment rather than for implementation of display pixels, so that the number of alignment assembly grooves 212 is less than the number of first assembly grooves. For example, when 100 first assembly grooves 211 are formed, one or more second assembly grooves 212 may be formed. However, in the process of transferring the semiconductor LEDs 150 assembled in the second assembly grooves 212 onto the final wiring substrate, a minimum number of second assembly grooves for enabling alignment should be provided. For example, three or more second assembly grooves 212 may be formed in the assembly substrate. Since one or two assembly grooves can define a point or a line region only, the one or two assembly grooves can be used for alignment by which a two-dimensional (2D) region can be specified through three or more assembly grooves.

Each of the second assembly grooves 212 may have a smaller diameter than each of the first assembly grooves 211. Generally, when the diameter of the assembly groove is small so that the assembly groove is similar in size to the semiconductor LED, a time required to assemble the semiconductor LED may increase. However, since the number of second assembly grooves 212 is much smaller than the number of first assembly grooves 211, the time required to assemble the semiconductor LED 150 into the second assembly groove 212 does not greatly affect the assembly time in which all the semiconductor LEDs are assembled into the assembly substrate 210.

For example, the spacing between the assembly electrodes 213 and 214 may be smaller than the width of the semiconductor LED or the diameter of each assembly groove 211 or 212, so that the assembly position of the semiconductor LEDs can be more precisely fixed using the electric field.

In addition, an insulation layer 215 may be formed over the assembly electrodes 213 and 214 to protect the electrodes 213 and 214 from the fluid 220 and to prevent leakage of current flowing through the assembly electrodes 213 and 214. For example, the insulation layer 215 may be formed of an inorganic insulator such as silica or alumina or an inorganic insulator as a monolayer or multilayer structure. In addition, the insulation layer 215 may have a minimum thickness to prevent damage to the assembly electrodes 213 and 214 when the semiconductor LEDs 150 are assembled, and may have a maximum thickness to stably assemble the semiconductor LEDs 150.

A barrier 216 may be formed over the insulation layer 215. A partial region of the barrier 216 may be disposed over the assembly electrodes 213 and 214, and the remaining regions other the partial region may be disposed over the assembly substrate 210.

For example, when the assembly substrate 210 is manufactured, some of the barrier formed over the entire upper portion of the insulation layer 215 may be removed, thereby forming the assembly grooves 211 and 212 where the semiconductor LEDs 150 are coupled to the assembly substrate 210.

As shown in FIG. 8, the assembly groove 211 coupled to the semiconductor LED 150 may be formed in the assembly substrate 210, and a surface where the assembly groove 211 is formed may be in contact with the fluid 220. The assembly groove 211 can guide an accurate assembly position of the semiconductor LED 150.

Meanwhile, the assembly groove 211 may have a shape and a size corresponding to the shape of the semiconductor LED to be assembled. As a result, it is possible to prevent other semiconductor LEDs from being assembled into the assembly groove 211 or to prevent a plurality of semiconductor LEDs from being assembled into the assembly groove 211.

In addition, the depth of the assembly groove 211 may be smaller than a vertical height of each semiconductor LED 150. Accordingly, the semiconductor LED may be formed to protrude from the spacing between the barriers 216, and may easily contact a protrusion of the transfer substrate in a transfer process after completion of the assembly process.

Also, as shown in FIG. 7, after the assembly substrate 210 is disposed, an assembly device 240 including the magnetic body may move along the assembly substrate 210. The assembly device 240 may move in contact with the assembly substrate 210 so as to maximize the region to be affected by the magnetic field within the fluid 220. For example, the assembly device 240 may include a plurality of magnetic bodies or may include a magnetic body having a size corresponding to the assembly substrate 210. In this case, the movement distance of the assembly device 240 may be limited to within a predetermined range.

By the magnetic field generated by the assembly device 240, the semiconductor LEDs 150 in the chamber 150 may move toward the assembly device 240.

While the semiconductor LED 150 moves toward the assembly device 240, the semiconductor LED 150 may enter the assembly groove 211 and thus contact the assembly substrate 210.

The semiconductor LED 150 may be the same type of semiconductor LED manufactured by the same fabrication process. However, the semiconductor LED assembled into the first assembly groove 211 as shown in FIG. 7 may serve as a lighting semiconductor LED, and the other semiconductor LED assembled into the second assembly groove 212 may serve as the alignment semiconductor LED.

The semiconductor LED 150 may serve as a horizontal semiconductor LED, as shown in FIG. 8. The semiconductor LED 150 may include a first conductive semiconductor layer 155, an active layer 154, a second conductive semiconductor layer 153, a first conductive electrode 156, and a second conductive electrode 152. In addition, a magnetic layer may be formed under the conductive electrodes 152 and 156 so that the self-assembly process can be performed. However, the above-described example is merely an example, and the scope of the present disclosure is not limited thereto. Therefore, the above-described example can be applied to all kinds of semiconductor LEDs regardless of the vertical or horizontal semiconductor LEDs.

Further, the assembly groove 211 and/or the semiconductor LED 150 may be formed to include a pattern or a shape that enables the second conductive semiconductor layer 153 of the semiconductor LED 150 to be in contact with the assembly substrate 210.

On the other hand, due to an electric field generated by the assembly electrodes 213 and 214 of the assembly substrate 210, the semiconductor LED 150 contacting the assembly substrate 210 can be prevented from being separated by movement of the assembly device 240.

Therefore, according to the self-assembly method using the electromagnetic field shown in FIGS. 7 and 8, the plurality of semiconductor LEDs 150 can be simultaneously assembled into the semiconductor substrate 210.

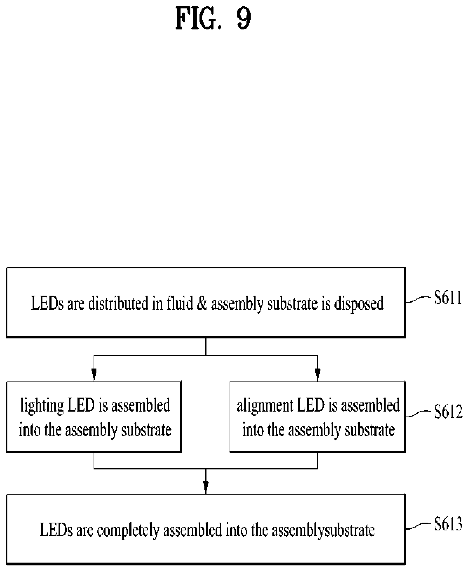

FIG. 9 is a flowchart illustrating a process in which the lighting semiconductor LED and the alignment semiconductor LED are assembled with each other according to the self-assembly method.

As described above, according to the self-assembly method using the electromagnetic field, the semiconductor LEDs are dispersed in the fluid, and the assembly substrate may be disposed over the chamber filled with the fluid (S611).

In addition, the semiconductor LEDs may have the same structure formed by the same fabrication process, and the assembly substrate may include an assembly groove for the lighting semiconductor LED and an assembly groove for the alignment semiconductor LED.

The semiconductor LED may be a horizontal semiconductor LED, and may be formed in a circular shape having no directivity to shorten the time required to assemble the semiconductor LED into the assembly groove.

In the self-assembly method, the plurality of semiconductor LEDs is simultaneously assembled into the assembly substrate within the fluid, the lighting semiconductor LED and the alignment semiconductor LED may be simultaneously assembled into the assembly substrate without an additional process (S612). Since all semiconductor LEDs are assembled into the assembly groove previously formed in the assembly substrate, the assembly process can be completed (S613).

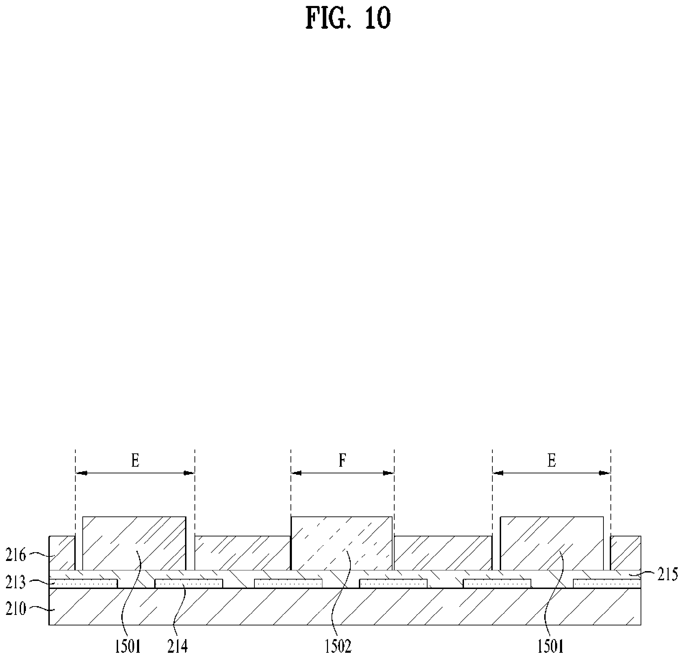

FIG. 10 is a cross-sectional view illustrating a structure in which the lighting semiconductor LED and the alignment semiconductor LED are assembled into an assembly substrate according to the self-assembly method.

Referring to FIG. 10, the assembly electrodes 213 and 214 may be formed over the assembly substrate 210, and the insulation layer 215 may be coated on the assembly electrodes 214 and 214. In addition, the assembly groove may be defined by the barrier 216 partially formed over the insulation layer 215.

The semiconductor LEDs assembled into the assembly substrate 210 can be broadly classified into the lighting semiconductor LED 1501 and the alignment semiconductor LED 1502. In addition, according to an aspect of the invention, as shown in FIG. 10, the width (E) of the first assembly groove assembled with the lighting semiconductor LED 1501 is larger than the width (F) of the second assembly groove assembled with the alignment semiconductor LED 1502.

Since the width (F) of the second assembly groove is smaller than the width (E) of the first assembly groove, the semiconductor LED can be used for more precise alignment purposes in the transfer step thereof in the future. For example, when the semiconductor LED has a horizontal length of 50 µm, the width of the first assembly groove assembled with the lighting semiconductor LED may be set to 55 µm, so that a spacing difference of about 5 µm or less between the lighting semiconductor LED and the alignment semiconductor LED may be considered efficient in terms of the assembly time. If the width of the assembly groove is almost the same as the horizontal length of the semiconductor LED, the semiconductor LED can be precisely assembled, but a long time will be consumed to assemble the semiconductor LED in consideration of a total number of semiconductor LEDs to be assembled.

However, the number of alignment semiconductor LEDs to be assembled is much smaller than the number of lighting semiconductor LEDs to be assembled, so that the entire assembly time of all semiconductor LEDs may be less affected by the assembly time of each semiconductor LED, and the second assembly groove may be formed to have the assembly groove of 51 µm to 53 µm, so that the second assembly groove can be used for more precise alignment purposes. That is, when using the semiconductor LED assembled into the first assembly groove, the position of the semiconductor LED may be changed within the range of 5 µm in the first assembly groove. In contrast, when using the other semiconductor LED assembled into the second assembly groove, the position of the semiconductor LED may be changed within the range of 1 µm to 3 µm in the second assembly groove. Thus, assuming that the semiconductor LED assembled into the second assembly groove while being more precisely controlled in position is utilized as an alignment index, precise transfer is also possible even in the final wiring substrate.

However, in the present disclosure, in embodiments not falling within the scope of the invention, the second assembly groove is not necessarily smaller than the first assembly groove. The reason why the alignment assembly groove is separately formed is to predetermine a positional deviation of the semiconductor LEDs in a transfer process after completion of the self-assembly process, thereby minimizing the alignment error of the semiconductor LEDs disposed on the wiring substrate in response to the positional deviation. Therefore, the second assembly groove may be equal to or larger in size than the first assembly groove. For more precise transfer and according to an aspect of the present invention, the second assembly groove is smaller in size than the first assembly groove.

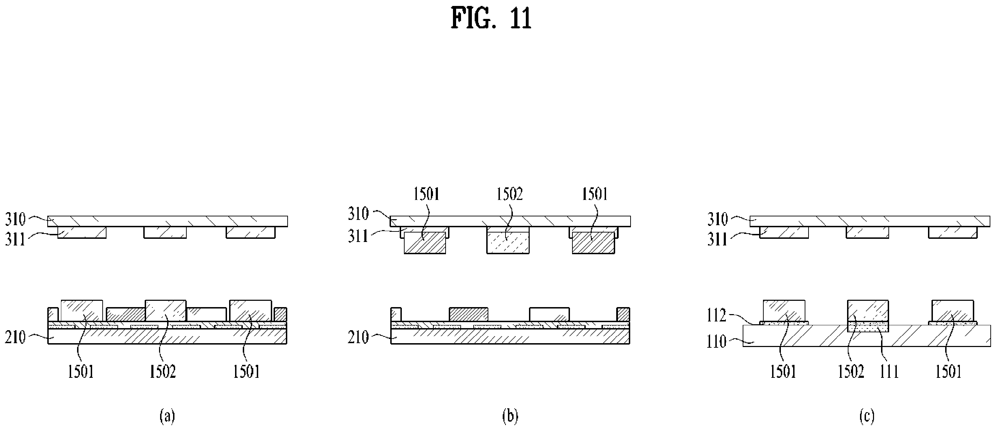

FIG. 11 is a cross-sectional view illustrating a method for manufacturing the display device using the assembly substrate and the wiring substrate.

FIG. 11(a) is a cross-sectional view illustrating a structure in which the lighting semiconductor devices (LEDs) 1501 and 1502 assembled into the assembly substrate 210 and the transfer substrate 310 including the protrusion 311 are vertically aligned with each other.

The semiconductor LEDs formed in the assembly substrate 210 may include the lighting semiconductor LED 1501 and the alignment semiconductor LED 1502.

In addition, the protrusion 311 of the transfer substrate may have sufficient adhesive force required to transfer the semiconductor LEDs 1501 and 1502.

The protrusions 311 may be arranged at intervals of a predetermined distance corresponding to the spacing between the semiconductor LEDs 1501 and 1502 of the assembly substrate 210. In addition, the alignment process may be performed to accurately transfer the protrusions 311 and the semiconductor LEDs 1501 and 1502.

For example, in the alignment process, any one of the assembly substrate 210 and the transfer substrate 310 may horizontally move with respect to the other one, and may then vertically move with respect to the other one, so that the alignment process can be performed. Thereafter, it is determined whether the position of the protrusion 311 of the transfer substrate corresponding to the semiconductor LED overlaps with the position of the semiconductor LEDs 1501 and 1502 of the assembly substrate 210 by the camera sensor and the like. In this case, if the position of the protrusion 311 of the transfer substrate overlaps with the position of the semiconductor LEDs 1501 and 1502 of the assembly substrate 210, the semiconductor LEDs may be transferred in response to the protrusion 311, and the assembly substrate 210 may be removed.

In addition, the assembly substrate 210 and the transfer substrate 310 may include alignment keys for alignment at positions corresponding to each other. For example, the alignment keys may be formed into the respective substrates while having the same uneven structure. In this case, the alignment keys may be in contact with each other. However, the scope of the present disclosure is not limited thereto, and other alignment keys having various structures conceivable by those skilled in the art are also possible.

On the other hand, if the number of semiconductor LEDs to be assembled into the assembly substrate 210 is small, it is possible to determine whether the protrusion 311 of the transfer substrate 310 overlaps with each of the semiconductor LEDs of the assembly substrate 210 as described above, and the transfer process can be performed according to the result of such determination. However, if the number of semiconductor LEDs to be assembled into the assembly substrate 210 is extremely large, a long inspection time is consumed to recognize each of the semiconductor LEDs and the position of a protrusion corresponding to the semiconductor LED. Therefore, assuming that the alignment key for the assembly substrate and the other alignment key for the transfer substrate are formed, the presence or absence of overlapping between the two alignment keys is determined, so that the transfer process of the semiconductor LEDs can be performed according to the result of determination.

FIG. 11(b) is a cross-sectional view illustrating a structure formed after the semiconductor LEDs 1501 and 1502 are transferred from the assembly substrate 210 to the transfer substrate 310.

Referring to FIG. 11(b), the semiconductor LEDs 1501 and 1502 may be stably transferred onto the protrusion 311 of the transfer substrate 310.

The protrusion 311 may be a flexible film material such as polydimethylsiloxane (PDMS) having sufficient adhesive force to contact and transfer the semiconductor LED. In addition, the main material of the transfer substrate 310 supporting the protrusion 311 may include at least one of polyethylene terephthalate (PET), polycarboxylate ether (PCE), and glass.

FIG. 11(c) is a cross-sectional view illustrating a structure formed after the semiconductor LEDs 1501 and 1502 are transferred from the protrusions 311 of the transfer substrate 310 to the wiring substrate 110.

The wiring substrate 110 may include an electrode unit for electrically connecting the lighting semiconductor LED 1501 to the wiring substrate 110.

On the other hand, the electrode unit is not formed at the position where the alignment semiconductor LED 1502 is transferred. The alignment semiconductor LED 1502 is transferred for precise alignment in the process of transferring from the transfer substrate 310 to the wiring substrate 110, so that the alignment semiconductor LED may not serve as a light emitting device (LED) after completion of the future wiring process.

In addition, an alignment mark 111 corresponding to the alignment semiconductor LED may be formed over the wiring substrate 110 at the transfer position where the alignment semiconductor LED 1502 is transferred.

In addition, the wiring substrate 110 may include not only the above-described alignment mark 111, but also another alignment key having the same structure as the alignment key of the transfer substrate 310 at a position corresponding to the alignment key of the transfer substrate 310.

In addition, an adhesive layer for stably fixing the semiconductor LED 150 to the wiring substrate 110 may be formed in the wiring substrate 110. The adhesive layer may be, for example, an anisotropic conductive adhesive layer, and the semiconductor LED 150 can be wiring-processed while being transferred onto the substrate.

In addition, a reflective layer may be disposed at a position where the lighting semiconductor LED 1501 of the wiring substrate 110 will be transferred. The reflective layer may allow light emitted toward the wiring substrate 110 to be reflected when the lighting semiconductor LED 1501 is driven, resulting in an increase in external light extraction efficiency.

In addition, the arrangement spacing among the adhesive layer, the electrode unit, and the reflective layers should be identical to the arrangement spacing among the semiconductor LEDs disposed in the transfer substrate 310. Therefore, in order to accurately transfer the semiconductor LEDs from the transfer substrate 310 to the wiring substrate 110, the alignment process may be performed.

The alignment process may include photographing, by the camera, each of the transfer substrate having the semiconductor LED and the wiring substrate formed before the semiconductor LEDs are transferred. In this case, the photographing process may be performed only at a specified position where the semiconductor LEDs will be transferred at the wiring substrate.

For precise alignment, the wiring substrate 110 may be formed of light transmissive material. Thus, the step of performing alignment between the transfer substrate 310 and the wiring substrate 110 may be performed using the image photographed by the camera disposed at the rear surface of the wiring substrate not facing the transfer substrate 310.

Specifically, the camera installed at the rear surface of the wiring substrate 110 may photograph the semiconductor LED of the transfer substrate 310 and the front surface of the wiring substrate 110 where the semiconductor LED will be transferred. Thereafter, through the image photographed by the camera, the region corresponding to the semiconductor LEDs of the transfer substrate 310 may overlap the other region corresponding to the semiconductor LEDs of the wiring substrate 110, so that an accurate position to be used for such transfer can be determined or established.

On the other hand, if the number of semiconductor LEDs to be transferred onto the wiring substrate 110 is large, a long inspection time is consumed to mark the region corresponding to each of the semiconductor LEDs on the wiring substrate 10 and to determine whether the marked region overlaps with the semiconductor LED. Therefore, assuming that the alignment corresponding to the transfer substrate and the alignment key corresponding to the wiring substrate are formed, the transfer process of the semiconductor LED can be performed after confirming whether the alignment keys overlap each other.

However, the alignment key formed in the transfer substrate is highly likely to be deformed through multiple transfer processes. Since the transfer substrate is formed of a flexible material having adhesive force required to transfer the semiconductor LED, the transfer substrate may be stretched or deformed by repeated transfer processes.

Furthermore, the semiconductor LEDs to be transferred onto the transfer substrate may have a positional deviation before and after the transfer process is performed due to physical properties of the transfer substrate.

Meanwhile, the alignment key has already been formed in the transfer substrate, it is impossible for the positional deviation to be reflected into the transfer process. As a result, if the transfer process is performed based on the alignment key, an alignment error of the semiconductor LEDs may occur due to the positional deviation.

Therefore, assuming that the alignment key previously formed in the transfer substrate is used, the alignment error of the semiconductor LEDs may become serious in proportion to the increasing number of transfer processes.

As a result, the alignment step configured to use not only the above alignment key formed in the transfer substrate, but also an additional alignment mark capable of minimizing the alignment error of the semiconductor LEDs may be required.

According to an aspect of the invention, the alignment semiconductor LED is used as the alignment mark.

In the self-assembly process, the alignment semiconductor LED is assembled into the assembly substrate, is transferred onto the transfer substrate, and is finally transferred onto the wiring substrate.

In a situation where the transfer process is performed in the transfer substrate and the transfer process is performed on the wiring substrate, this transfer process is performed in the same manner as in the lighting semiconductor LED, even when the alignment error of the semiconductor LEDs is generated before and after the transfer process, the alignment error can be reflected to the transfer process without change. That is, assuming that the alignment semiconductor LED is used for alignment purposes, the influence of the alignment error likely to be generated in the process of transferring the semiconductor LEDs on the wiring substrate can be ignored.

Therefore, the step for performing alignment using the alignment semiconductor LED can be divided into the following steps. First, the first alignment step in which the alignment keys formed at the corresponding positions of the transfer substrate 310 and the wiring substrate 110 overlap each other can be performed. Furthermore, the second alignment step in which the alignment marks 111 formed in the regions corresponding to the alignment semiconductor LED 1502 formed in the transfer substrate 310 and the alignment semiconductor LED previously formed in the wiring substrate 110 overlap each other can be performed.

Through the first alignment step, an approximate transfer position where the semiconductor LED of the transfer substrate 310 will be transferred onto the wiring substrate 110 is confirmed. Through the second alignment step, the semiconductor LED of the transfer substrate 310 can be precisely transferred onto the wiring substrate 110.

On the other hand, in the process of manufacturing the display device using the transfer substrate 310 shown in FIG. 11, the transfer process according to the present disclosure is performed two times, but is not limited thereto. For example, an additional transfer process may be performed to form a conductive electrode for the vertical semiconductor LED or to form the light extraction structure of the semiconductor LED.

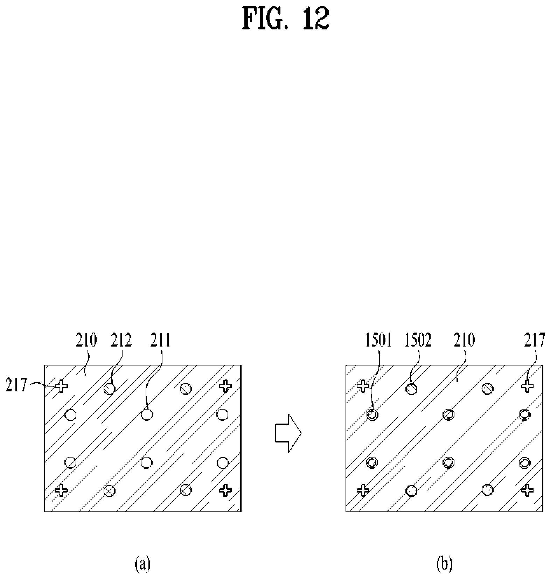

FIG. 12 is a plan view illustrating the assembly substrate and semiconductor LEDs assembled into the assembly substrate according to the present disclosure.

Referring to FIG. 12(a), the first assembly groove 211 for the lighting semiconductor LED and the second assembly groove 212 for the alignment semiconductor LED are disposed in the assembly substrate 210. In addition, when the semiconductor LEDs are transferred from the assembly substrate 210 to the transfer substrate, the alignment key 217 for accurate alignment may be formed in advance.

FIG. 12(b) is a plan view illustrating the structure formed after the semiconductor LEDs are assembled into the assembly substrate of FIG. 12(a) according to the self-assembly method using the electromagnetic field.

As described above, the lighting semiconductor LED 1501 and the alignment semiconductor LED 1502 are the same semiconductor LEDs formed by the same fabrication process, but the role of the semiconductor LEDs to be used in future may be determined differently according to the assembly grooves of the assembly substrate 210.

As shown in FIG. 12(b), the lighting semiconductor LED 1501 may be assembled with a clearance space into the first assembly groove. In contrast, the second assembly groove is smaller in width than the first assembly groove, so that the alignment semiconductor LED can be closely assembled with the second assembly groove as shown in FIG. 12(b).

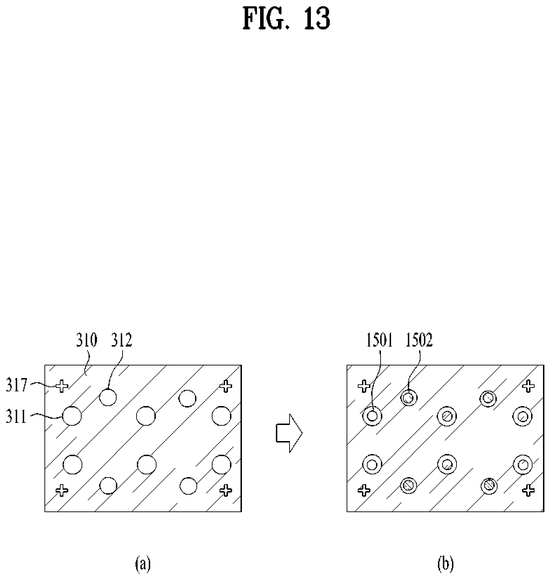

FIG. 13 is a plan view illustrating the transfer substrate and semiconductor LEDs transferred to the transfer substrate according to the present disclosure.

Referring to FIG. 13(a), the alignment key 317 having a structure corresponding to the alignment key 217 previously formed in the assembly substrate 210 of FIG. 12(b) may be disposed in the transfer substrate 310. One protrusion 311 may be disposed at a position corresponding to the lighting semiconductor LED assembled into the assembly substrate and the other protrusion 312 may be disposed at a position corresponding to the alignment semiconductor LED assembled in the assembly substrate.

The width of each of the protrusions 311 and 312 may be larger than that of each of the semiconductor LEDs so that the semiconductor LEDs can be stably bonded and transferred onto the substrate.

FIG. 13(b) is a plan view illustrating the semiconductor LEDs 1501 and 1502 transferred onto the transfer substrate through the protrusions of FIG. 13(a).

The semiconductor LEDs assembled into the assembly substrate of FIG. 12(b) may be transferred onto the transfer substrate 310 while maintaining the same pitch therebetween, as shown in FIG. 13(b).

However, the alignment key formed in the transfer substrate may be formed of a flexible material such as a material constituting the protrusions formed in the transfer substrate, so that the alignment key may be deformed by repeated execution of the transfer process.

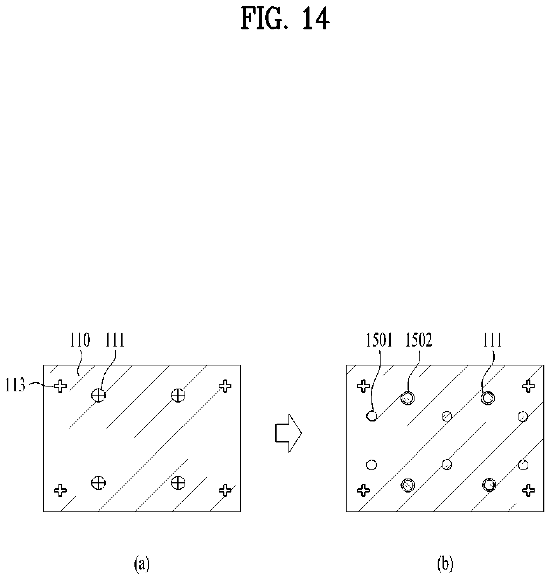

FIG. 14 is a plan view illustrating the wiring substrate and the semiconductor LEDs transferred onto the wiring substrate according to the present disclosure.

Referring to FIG. 14(a), the alignment key 113 having a structure corresponding to the alignment key 317 previously formed in the transfer substrate 310 of FIG. 12(b) is formed in the wiring substrate 110. The alignment key 113 includes an uneven structure.

In addition, the alignment mark 111 is formed at a position corresponding to the alignment semiconductor LED of the transfer substrate.

FIG. 14(b) is a plan view illustrating the semiconductor LEDs 1501 and 1502 transferred onto the wiring substrate 110 of FIG. 14(a).

As described above, the process of transferring the semiconductor LEDs 1501 and 1502 onto the wiring substrate 110 is as follows.

First, the alignment key formed in the transfer substrate and the other alignment key formed in the wiring substrate overlap each other so that the appropriate transfer position can be confirmed based on the result of overlapping between the two alignment keys.

The reason why the final position where the transfer process will be performed on the wiring substrate using the above-described alignment key is not determined is that the above alignment key has already been formed in the transfer substrate and thus positional deviation between the semiconductor LEDs cannot be reflected in the transfer process.

Here, the positional deviation may refer to a state in which the average position of the semiconductor LED array is changed before and after the transfer process due to physical properties (e.g., a stamp structure and a flexible material) of the transfer substrate. Therefore, when the transfer process is performed only using the alignment keys, the positional deviation is reflected in the transfer process without change so that the alignment error of the semiconductor LEDs may occur in the wiring substrate. In addition, as the transfer process is repeatedly performed, each of the alignment keys may be deformed so that the above alignment error may become serious.

Therefore, when the approximate transfer position where the semiconductor LEDs of the transfer substrate will be transferred is determined in the wiring substrate using the alignment key, the alignment semiconductor LED disposed in the transfer substrate and the alignment mark 111 formed in the wiring substrate overlap each other so that the accurate transfer position can be determined.

The alignment semiconductor LED is formed by the same transfer process as in the peripheral semiconductor LEDs, and the average position change of the semiconductor LED array before and after the transfer process is reflected in the transfer process without change, so that the alignment error caused by the positional deviation generated before and after the transfer process may not occur.

As a result, when the alignment step is performed two times, the alignment semiconductor LED 1502 is transferred onto the alignment mark 111 as shown in FIG. 14(b), and the lighting semiconductor LEDs 1501 can be precisely transferred onto the substrate while maintaining a constant pitch with respect to the alignment semiconductor LED 1502.

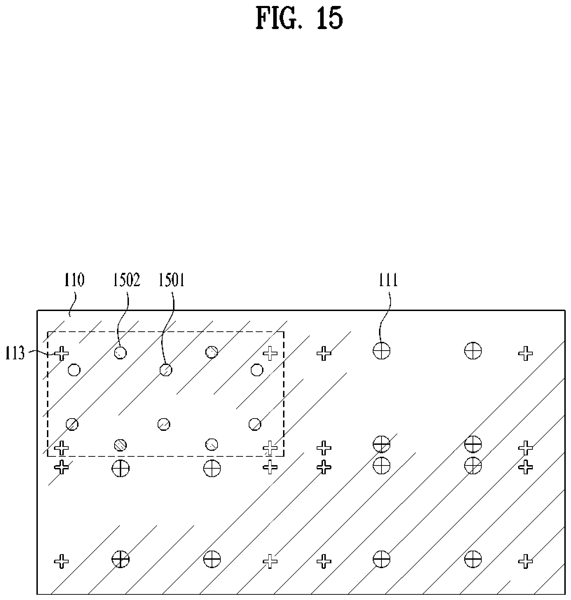

FIG. 15 is a plan view illustrating semiconductor LEDs transferred only in a partial region of the wiring substrate.

In FIG. 15, the region denoted by dotted lines may refer to an array of the semiconductor LEDs transferred onto the transfer substrate of FIG. 14(b).

In order to implement the large-area display device, the process of transferring the semiconductor LEDs from the transfer substrate to the wiring substrate may be performed multiple times.

For example, when using the wiring substrate 110 shown in FIG. 15, the transfer process should be performed four times so that all regions of the wiring substrate 110 can be filled with the semiconductor LEDs.

Each transfer process should be precisely adjusted in the wiring substrate 110. As shown in FIG. 15, such precise transfer can be performed by the alignment mark 111 and the alignment semiconductor LED 1502 transferred onto the alignment mark 111.

In more detail, when the transfer substrate overlaps with the wiring substrate 110 to perform transfer of the semiconductor LEDs, overlapping or non-overlapping of the alignment keys 113 may be determined. If the alignment keys 113 overlap each other, the transfer position may be precisely adjusted in a manner that the alignment key 111 of the wiring substrate 110 overlaps with the alignment semiconductor LED of the transfer substrate and the lighting semiconductor LED and the lighting semiconductor LED are then transferred onto the wiring substrate 110.

In FIG. 15, the region denoted by the dotted lines illustrates a plan view of the structure formed after the transfer process is performed by the above method, the lighting semiconductor LED 1501 and the alignment semiconductor LED 1502 may be transferred at the accurate position within the wiring substrate 110.

In addition, the number of lighting semiconductor LEDs to be transferred by only one transfer may be much larger than the number of alignment semiconductor LEDs. For example, the number of lighting semiconductor LEDs for each unit area within the wiring substrate may be at least 100 times larger than the number of alignment semiconductor LEDs for each unit area within the wiring substrate.

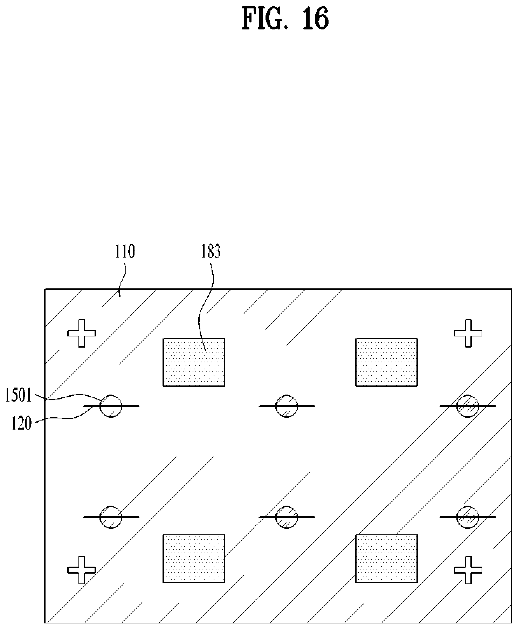

FIG. 16 is a plan view illustrating the wiring substrate after completion of a wiring process that is performed on the semiconductor LEDs transferred to the wiring substrate.

Referring to FIG. 16, the lighting semiconductor LED 1501 forms the wiring electrode 120 to be electrically connected to the wiring substrate 110, so that the lighting semiconductor LED 150 can emit a specific color of light when the display device is driven.

In contrast, as shown in FIG. 16, a blackout layer (or a black layer) 183 is selectively formed at an upper portion of the position where the alignment semiconductor LED of the wiring substrate 110 is transferred. The blackout layer 183 is formed of a material having low light transmittance. For example, the blackout layer 183 may be formed of a black resin or a black colored photoresist.

The blackout layer 183 prevents light generated by the alignment semiconductor LED from leaking to the outside when the display device is driven. In more detail, although the alignment semiconductor LED is not electrically connected to the wiring substrate 110, first light generated by the peripheral lighting semiconductor LED 1501 may be transmitted to the lighting semiconductor LED, so that second light may be generated by the alignment semiconductor LED, so that the blackout layer 183 can prevent such light from being emitted to the outside.

The invention is defined by the appended claims.

## Claims

1. A method for manufacturing a display device, the method comprising:
assembling a lighting semiconductor light emitting device, LED (1501), of a plurality of semiconductor LEDs (150) into a first assembly groove (211) of an assembly substrate (210);
assembling an alignment semiconductor LED (1502) of the plurality of semiconductor LEDs (150) into a second assembly groove (212) of the assembly substrate (210);
transferring the semiconductor LEDs (150) assembled into the assembly substrate (210) from the assembly substrate (210) to a transfer substrate (310); and
transferring the semiconductor LEDs (150) transferred to the transfer substrate (310) from the transfer substrate (310) to a wiring substrate (110),
wherein assembling the lighting semiconductor LED into the first assembly groove (211) and assembling the alignment semiconductor LED (1502) into the second assembly groove (212) each includes:
performing self-assembling using an electric field and a magnetic field,
wherein
the lighting semiconductor LED (1501) is electrically connected to a wiring electrode of the wiring substrate (110) and the alignment semiconductor LED (1502) is not electrically connected to a wiring electrode of the wiring substrate (110),
the transfer substrate (310) and the wiring substrate (110) have alignment keys (113, 317) having a same uneven structure for alignment at positions where the transfer substrate (310) and the wiring substrate (110) are arranged to correspond to each other, and
wherein aligning the transfer substrate (310) and the wiring substrate (110) includes:
positioning the alignment keys (113, 317) to overlap each other; and
positioning the alignment semiconductor LED (1502) transferred to the transfer substrate (310) to overlap an alignment mark (111) of the wiring substrate (110) at a position corresponding to the alignment semiconductor LED (1502),
the first assembly groove (211) has a larger width than a width of the second assembly groove (212),
further comprising forming a blackout layer (183) having low light transmittance disposed at an upper surface of the alignment semiconductor LED (1502), the blackout layer (183) is configured to prevent light generated by the alignment semiconductor LED (1502) from leaking to the outside.

2. The method according to claim 1, wherein:
the lighting semiconductor LED (1501) and the alignment semiconductor LED (1502) have a same structure formed by a same fabrication process.

3. The method according to claim 2, wherein assembling the lighting semiconductor LED (1501) into the first assembly groove (211) or assembling the alignment semiconductor LED (1502) into the second assembly groove (212) further includes:
introducing the semiconductor LEDs (150) into a fluid chamber;
disposing the assembly substrate (210) at an upper surface of the fluid chamber;
causing a corresponding semiconductor LED (150) floating in the fluid chamber to be in contact with the first assembly groove (211) or the second assembly groove (212) using an assembly device (240) having a magnetic material; and
assembling the corresponding semiconductor LED (150) into the first assembly groove (211) or the second assembly groove (212) based on the electric field received through an assembly electrode (213, 214) of the assembly substrate (210).

4. The method according to claim 1, wherein:
the transfer substrate (310) includes a plurality of protrusions (311) formed at a position corresponding to the lighting semiconductor LED (1501) assembled into the first assembly groove (211), and at a position corresponding to the alignment semiconductor LED (1502); and
transferring the semiconductor LEDs (150) assembled into the assembly substrate (210) from the assembly substrate (210) to the transfer substrate (310) includes:
overlapping the assembly substrate (210) and the transfer substrate (310) such that the protrusions (311) and the semiconductor LEDs (150) overlap each other;
causing the overlapped semiconductor LEDs (150) to contact the protrusions (311) so that the semiconductor LEDs (150) are fixed; and
removing the assembly substrate (210).

5. The method according to claim 1, wherein:
the assembly substrate (210) and the transfer substrate (310) have alignment keys (217, 317) having a same uneven structure for alignment at positions where the assembly substrate (210) and the transfer substrate (310) are arranged to correspond to each other.

6. The method according to claim 5, wherein transferring the semiconductor LEDs (150) assembled into the assembly substrate (210) from the assembly substrate (210) to the transfer substrate (310) includes:
overlapping the alignment keys (217, 317) at the positions where the assembly substrate (210) and the transfer substrate (310) are arranged to correspond to each other.

7. The method according to claim 1, wherein transferring the semiconductor LEDs (150) transferred to the transfer substrate (310) from the transfer substrate (310) to the wiring substrate (110) includes:
aligning the transfer substrate (310) and the wiring substrate (110) such that the semiconductor LEDs (150) are disposed at a partial region of the wiring substrate (110) corresponding to the semiconductor LEDs (150) transferred to the transfer substrate (310);
fixing the semiconductor LEDs (150) to the partial region of the wiring substrate (110) corresponding to the semiconductor LEDs (150); and
removing the transfer substrate (310).

8. The method according to claim 7, wherein:
the wiring substrate (110) is formed of a light-transmissive material; and
the aligning of the transfer substrate (310) and the wiring substrate (110) is performed using an image captured by a camera disposed at a back surface of the wiring substrate (110).

9. The method according to claim 8, wherein aligning the transfer substrate (310) and the wiring substrate (110) includes:
overlapping a region of the transfer substrate (310) corresponding to the semiconductor LEDs (150) and the partial region of the wiring substrate (110) corresponding to the semiconductor LEDs (150) using the image captured by the camera.

10. The method according to claim 1, further comprising:
after transferring the semiconductor LEDs (150) to the wiring substrate (110),
performing a wiring process to electrically connect the lighting semiconductor LED (1501) to the wiring substrate (110).

11. The method according to claim 1, wherein the assembly substrate (210) includes:
a first assembly substrate assembled with a first semiconductor LED configured to emit a first colored light when the display device is driven; and
a second assembly substrate assembled with a second semiconductor LED configured to emit a second colored light different from the first colored light.

12. A display device comprising:
a wiring substrate (110); and
a plurality of semiconductor light emitting devices, LEDs (150), disposed at the wiring substrate (110),
wherein the plurality of semiconductor LEDs (150) includes a lighting semiconductor LED (1501) and an alignment semiconductor LED (1502);
wherein:
the lighting semiconductor LED (1501) and the alignment semiconductor LED (1502) have a same shape and a same light emitting color;
the lighting semiconductor LED (1501) is electrically connected to a wiring electrode of the wiring substrate (110) and the alignment semiconductor LED (1502) is not electrically connected to a wiring electrode of the wiring substrate (110); and
a blackout layer (183) having low light transmittance is disposed at an upper surface of the alignment semiconductor LED (1502) configured to prevent light generated by the alignment semiconductor LED (1502) from leaking to the outside;
wherein
the wiring substrate (110) includes:
an alignment key (113) having an uneven structure,
wherein the alignment semiconductor LED (1502) is positioned to overlap an alignment mark (111) of the wiring substrate (110).

13. The display device according to claim 12, wherein:
a number of the lighting semiconductor LEDs (1501) for each unit area of the wiring substrate (110) is at least 100 times larger than a number of the alignment semiconductor LEDs (1502) for each unit area of the wiring substrate (110).

## Patentansprüche

1. Verfahren zur Herstellung einer Anzeigevorrichtung, wobei das Verfahren aufweist:
Montieren einer Beleuchtungs-Halbleiter-Leuchtvorrichtung, LED (1501), aus mehreren Halbleiter-LEDs (150) in eine erste Montagenut (211) eines Montagesubstrats (210);
Montieren einer Ausrichtungs-Halbleiter-LED (1502) der mehreren Halbleiter-LEDs (150) in eine zweite Montagenut (212) des Montagesubstrats (210);
Transferieren der in dem Montagesubstrat (210) montierten Halbleiter-LEDs (150) von dem Montagesubstrat (210) auf ein Transfersubstrat (310); und
Transferieren der auf das Transfersubstrat (310) transferierten Halbleiter-LEDs (150) von dem Transfersubstrat (310) auf ein Verdrahtungssubstrat (110),
wobei das Montieren der Beleuchtungs-Halbleiter-LED in die erste Montagenut (211) und das Montieren der Ausrichtungs-Halbleiter-LED (1502) in die zweite Montagenut (212) jeweils aufweist:
Durchführen einer Selbstmontage unter Verwendung eines elektrischen Feldes und eines Magnetfeldes,
wobei
die Beleuchtungs-Halbleiter-LED (1501) elektrisch mit einer Verdrahtungselektrode des Verdrahtungssubstrats (110) verbunden ist und die Ausrichtungs-Halbleiter-LED (1502) nicht elektrisch mit einer Verdrahtungselektrode des Verdrahtungssubstrats (110) verbunden ist,
das Transfersubstrat (310) und das Verdrahtungssubstrat (110) Ausrichtungs-Passformen (113, 317) aufweisen, die eine gleiche ungleichmäßige Struktur zur Ausrichtung an Positionen aufweisen, an denen das Transfersubstrat (310) und das Verdrahtungssubstrat (110) so angeordnet sind, dass sie einander entsprechen, und
wobei das Ausrichten des Transfersubstrats (310) und des Verdrahtungssubstrats (110) aufweist:
Positionieren der Ausrichtungs-Passform (113, 317), so dass sie einander überlappen; und
Positionieren der auf das Transfersubstrat (310) transferierten Ausrichtungs-Halbleiter-LED (1502), so dass sie eine Ausrichtungsmarkierung (111) des Verdrahtungssubstrats (110) an einer Position überlappen, die der Ausrichtungs-Halbleiter-LED (1502) entspricht,
die erste Montagenut (211) eine größere Breite als eine Breite der zweiten Montagenut (212) aufweist,
das ferner das Bilden einer Verdunkelungsschicht (183) mit geringer Lichtdurchlässigkeit aufweist, die an einer oberen Fläche der Ausrichtungs-Halbleiter-LED (1502) angeordnet ist, wobei die Verdunkelungsschicht (183) konfiguriert ist, zu verhindern, dass von der Ausrichtungs-Halbleiter-LED (1502) erzeugtes Licht nach außen dringt.

2. Verfahren nach Anspruch 1, wobei:
die Beleuchtungs-Halbleiter-LED (1501) und die Ausrichtungs-Halbleiter-LED (1502) die gleiche Struktur aufweisen, die durch den gleichen Herstellungsprozess gebildet wird.

3. Verfahren nach Anspruch 2, wobei das Montieren der Beleuchtungs-Halbleiter-LED (1501) in die erste Montagenut (211) oder das Montieren der Ausrichtungs-Halbleiter-LED (1502) in die zweite Montagenut (212) ferner aufweist:
Einführen der Halbleiter-LEDs (150) in eine Fluidkammer;
Anordnen des Montagesubstrats (210) an einer oberen Fläche der Fluidkammer;
Bewirken, dass eine entsprechende Halbleiter-LED (150), die in der Fluidkammer schwimmt, mit der ersten Montagenut (211) oder der zweiten Montagenut (212) unter Verwendung einer Montagevorrichtung (240), die ein magnetisches Material aufweist, in Kontakt kommt; und
Montieren der entsprechenden Halbleiter-LED (150) in die erste Montagenut (211) oder die zweite Montagenut (212) basierend auf dem elektrischen Feld, das durch eine Montageelektrode (213, 214) des Montagesubstrats (210) empfangen wird.

4. Verfahren nach Anspruch 1, wobei:
das Transfersubstrat (310) mehrere Vorsprünge (311) aufweist, die an einer Position, die der in der ersten Montagenut (211) montierten Beleuchtungs-Halbleiter-LED (1501) entspricht, und an einer Position, die der Ausrichtungs-Halbleiter-LED (1502) entspricht, ausgebildet sind; und
Transferieren der in das Montagesubstrat (210) montierten Halbleiter-LEDs (150) von dem Montagesubstrat (210) zu dem Transfersubstrat (310) aufweist:
Überlappen des Montagesubstrats (210) und des Transfersubstrats (310), so dass sich die Vorsprünge (311) und die Halbleiter-LEDs (150) gegenseitig überlappen;
Bewirken, dass die überlappenden Halbleiter-LEDs (150) die Vorsprünge (311) berühren, so dass die Halbleiter-LEDs (150) fixiert werden; und
Entfernen des Montagesubstrats (210).

5. Verfahren nach Anspruch 1, wobei:
das Montagesubstrat (210) und das Transfersubstrat (310) Ausrichtungs-Passformen (217, 317) aufweisen, die eine gleiche ungleichmäßige Struktur zur Ausrichtung an Positionen aufweisen, an denen das Montagesubstrat (210) und das Transfersubstrat (310) so angeordnet sind, dass sie einander entsprechen.

6. Verfahren nach Anspruch 5, wobei das Transferieren der in das Montagesubstrat (210) montierten Halbleiter-LEDs (150) von dem Montagesubstrat (210) auf das Transfersubstrat (310) aufweist:
Überlappen der Ausrichtungs-Passformen (217, 317) an den Positionen, an denen das Montagesubstrat (210) und das Transfersubstrat (310) so angeordnet sind, dass sie einander entsprechen.

7. Verfahren nach Anspruch 1, wobei das Transferieren der auf das Transfersubstrat (310) transferierten Halbleiter-LEDs (150) von dem Transfersubstrat (310) auf das Verdrahtungssubstrat (110) aufweist:
Ausrichten des Transfersubstrats (310) und des Verdrahtungssubstrats (110), so dass die Halbleiter-LEDs (150) in einem Teilbereich des Verdrahtungssubstrats (110) angeordnet sind, der den auf das Transfersubstrat (310) transferierten Halbleiter-LEDs (150) entspricht;
Fixieren der Halbleiter-LEDs (150) an dem Teilbereich des Verdrahtungssubstrats (110), der den Halbleiter-LEDs (150) entspricht; und
Entfernen des Transfersubstrats (310).

8. Verfahren nach Anspruch 7, wobei:
das Verdrahtungssubstrat (110) aus einem lichtdurchlässigen Material ausgebildet ist; und
das Ausrichten des Transfersubstrats (310) und des Verdrahtungssubstrats (110) unter Verwendung eines Bildes durchgeführt wird, das von einer Kamera aufgenommen wird, die an einer Rückseite des Verdrahtungssubstrats (110) angeordnet ist.

9. Verfahren nach Anspruch 8, wobei das Ausrichten des Transfersubstrats (310) und des Verdrahtungssubstrats (110) aufweist:
Überlappen eines Bereichs des Transfersubstrats (310), der den Halbleiter-LEDs (150) entspricht, und des Teilbereichs des Verdrahtungssubstrats (110), der den Halbleiter-LEDs (150) entspricht, unter Verwendung des von der Kamera erfassten Bildes.

10. Verfahren nach Anspruch 1, das ferner aufweist:
nach dem Transferieren der Halbleiter-LEDs (150) auf das Verdrahtungssubstrat (110), Durchführen eines Verdrahtungsprozesses, um die Beleuchtungs-Halbleiter-LED (1501) mit dem Verdrahtungssubstrat (110) elektrisch zu verbinden.

11. Verfahren nach Anspruch 1, wobei das Montagesubstrat (210) aufweist:
ein erstes Montagesubstrat, das mit einer ersten Halbleiter-LED bestückt ist, die konfiguriert ist, ein erstes farbiges Licht zu emittieren, wenn die Anzeigevorrichtung angesteuert wird; und
ein zweites Montagesubstrat, das mit einer zweiten Halbleiter-LED bestückt ist, die konfiguriert ist, ein zweites farbiges Licht zu emittieren, das sich von dem ersten farbigen Licht unterscheidet.

12. Anzeigevorrichtung, die aufweist:
ein Verdrahtungssubstrat (110); und
mehrere lichtemittierende Halbleitervorrichtungen, LEDs (150), die auf dem Verdrahtungssubstrat (110) angeordnet sind,
wobei die mehreren Halbleiter-LEDs (150) eine Beleuchtungs-Halbleiter-LED (1501) und eine Ausrichtungs-Halbleiter-LED (1502) aufweisen;
wobei:
die Beleuchtungs-Halbleiter-LED (1501) und die Ausrichtungs-Halbleiter-LED (1502) die gleiche Form und die gleiche Lichtemissionsfarbe haben;
die Beleuchtungs-Halbleiter-LED (1501) elektrisch mit einer Verdrahtungselektrode des Verdrahtungssubstrats (110) verbunden ist und die Ausrichtungs-Halbleiter-LED (1502) nicht elektrisch mit einer Verdrahtungselektrode des Verdrahtungssubstrats (110) verbunden ist; und
eine Verdunkelungsschicht (183) mit geringer Lichtdurchlässigkeit an einer oberen Oberfläche der Ausrichtungs-Halbleiter-LED (1502) angeordnet ist, die konfiguriert ist, zu verhindern, dass von der Ausrichtungs-Halbleiter-LED (1502) erzeugtes Licht nach außen dringt;
wobei
das Verdrahtungssubstrat (110) aufweist:
einen Ausrichtungs-Passform (113) mit einer ungleichmäßigen Struktur,
wobei die Ausrichtungs-Halbleiter-LED (1502) so positioniert ist, dass sie eine Ausrichtungsmarkierung (111) des Verdrahtungssubstrats (110) überlappt.

13. Anzeigevorrichtung nach Anspruch 12, wobei:
eine Anzahl der Beleuchtungs-Halbleiter-LEDs (1501) für jede Flächeneinheit des Verdrahtungssubstrats (110) mindestens 100 mal größer ist als eine Anzahl der Ausrichtungs-Halbleiter-LEDs (1502) für jede Flächeneinheit des Verdrahtungssubstrats (110).

## Revendications

1. Procédé de fabrication d'un dispositif d'affichage, ledit procédé comprenant :
l'assemblage d'un dispositif électroluminescent à semi-conducteur, DEL, d'éclairage (1501), parmi une pluralité de DEL à semi-conducteur (150), dans une première rainure d'assemblage (211) d'un substrat d'assemblage (210) ;
l'assemblage d'un DEL à semi-conducteur d'alignement (1502) de la pluralité de DEL à semi-conducteur (150) dans une deuxième rainure d'assemblage (212) du substrat d'assemblage (210) ;
le transfert des DEL à semi-conducteur (150) assemblés dans le substrat d'assemblage (210) du substrat d'assemblage (210) vers un substrat de transfert (310) ; et
le transfert des DEL à semi-conducteur (150) transférés vers le substrat de transfert (310) du substrat de transfert (310) à un substrat de câblage (110),
où l'assemblage du DEL à semi-conducteur d'éclairage dans la première rainure d'assemblage (211) et l'assemblage du DEL à semi-conducteur d'alignement (1502) dans la deuxième rainure d'assemblage (212) comprennent chacun :
l'exécution d'un auto-assemblage au moyen d'un champ électrique et d'un champ magnétique,
où le DEL à semi-conducteur d'éclairage (1501) est connecté électriquement à une électrode de câblage du substrat de câblage (110) et le DEL à semi-conducteur d'alignement (1502) n'est pas connecté électriquement à une électrode de câblage du substrat de câblage (110),
le substrat de transfert (310) et le substrat de câblage (110) ont des repères d'alignement (113, 317) ayant la même structure irrégulière pour un alignement aux emplacements où le substrat de transfert (310) et le substrat de câblage (110) sont disposés de manière à correspondre l'un à l'autre, et
où l'alignement du substrat de transfert (310) et du substrat de câblage (110) comprend :
le positionnement des repères d'alignement (113, 317) de manière à se chevaucher l'un l'autre ; et
le positionnement du DEL à semi-conducteur d'alignement (1502) transféré vers le substrat de transfert (310) de manière à ce que celle-ci recouvre une marque d'alignement (111) du substrat de câblage (110) à un emplacement correspondant au DEL à semi-conducteur d'alignement (1502),
la première rainure d'assemblage (211) ayant une largeur supérieure à la largeur de la deuxième rainure d'assemblage (212),
ledit procédé comprenant en outre la formation d'une couche d'obscurcissement (183) à faible transmission lumineuse disposée sur une surface supérieure du DEL à semi-conducteur d'alignement (1502), ladite couche d'occultation (183) étant prévue pour empêcher la diffusion vers l'extérieur de la lumière générée par le DEL à semi-conducteur d'alignement (1502).

2. Procédé selon la revendication 1, où :
le DEL à semi-conducteur d'éclairage (1501) et le DEL à semi-conducteur d'alignement (1502) ont une même structure formée par un même procédé de fabrication.

3. Procédé selon la revendication 2, où l'assemblage du DEL à semi-conducteur d'éclairage (1501) dans la première rainure d'assemblage (211) ou l'assemblage du DEL à semi-conducteur d'alignement (1502) dans la deuxième rainure d'assemblage (212) comprennent en outre :
l'introduction des DEL à semi-conducteur (150) dans une chambre de fluide ;
la disposition du substrat d'assemblage (210) sur une surface supérieure de la chambre de fluide ;
la mise en contact d'un DEL à semi-conducteur correspondant (150) flottant dans la chambre de fluide avec la première rainure d'assemblage (211) ou la deuxième rainure d'assemblage (212) au moyen d'un dispositif d'assemblage (240) pourvu d'un matériau magnétique ; et
l'assemblage du DEL à semi-conducteur correspondant (150) dans la première rainure d'assemblage (211) ou la deuxième rainure d'assemblage (212) sur la base du champ électrique reçu par une électrode d'assemblage (213, 214) du substrat d'assemblage (210).

4. Procédé selon la revendication 1, où :
le substrat de transfert (310) présente une pluralité de saillies (311) formées à un emplacement correspondant au DEL à semi-conducteur d'éclairage (1501) assemblé dans la première rainure d'assemblage (211), et à un emplacement correspondant au DEL à semi-conducteur d'alignement (1502) ; et
où le transfert des DEL à semi-conducteur (150) assemblés dans le substrat d'assemblage (210) du substrat d'assemblage (210) vers le substrat de transfert (310) comprend :
la superposition du substrat d'assemblage (210) et du substrat de transfert (310) de manière à superposer les saillies (311) et les DEL à semi-conducteur (150) ;
la mise en contact des DEL à semi-conducteur (150) superposés avec les saillies (311) de manière à fixer les DEL à semi-conducteur (150) ; et
le retrait du substrat d'assemblage (210).

5. Procédé selon la revendication 1, où :
le substrat d'assemblage (210) et le substrat de transfert (310) ont des repères d'alignement (217, 317) ayant la même structure irrégulière pour un alignement aux emplacements où le substrat d'assemblage (210) et le substrat de transfert (310) sont disposés de manière à correspondre l'un à l'autre.

6. Procédé selon la revendication 5, où le transfert des DEL à semi-conducteur (150) assemblés dans le substrat d'assemblage (210), du substrat d'assemblage (210) vers le substrat de transfert (310), comprend :
la superposition des repères d'alignement (217, 317) aux emplacements où le substrat d'assemblage (210) et le substrat de transfert (310) sont disposés de manière à correspondre l'un à l'autre.

7. Procédé selon la revendication 1, où le transfert des DEL à semi-conducteur (150) transférés vers le substrat de transfert (310), du substrat de transfert (310) vers le substrat de câblage (110), comprend :
l'alignement du substrat de transfert (310) et du substrat de câblage (110) de manière à disposer les DEL à semi-conducteur (150) dans une zone partielle du substrat de câblage (110) correspondant aux DEL à semi-conducteur (150) transférés vers le substrat de transfert (310) ;
la fixation des DEL à semi-conducteur (150) sur la zone partielle du substrat de câblage (110) correspondant aux DEL à semi-conducteur (150) ; et
le retrait du substrat de transfert (310).

8. Procédé selon la revendication 7, où :
le substrat de câblage (110) est constitué d'un matériau transmettant la lumière ; et
l'alignement du substrat de transfert (310) et du substrat de câblage (110) est effectué au moyen d'une image capturée par une caméra disposée sur une surface arrière du substrat de câblage (110).

9. Procédé selon la revendication 8, où l'alignement du substrat de transfert (310) et du substrat de câblage (110) comprend :
la superposition d'une zone du substrat de transfert (310) correspondant aux DEL à semi-conducteur (150) et de la zone partielle du substrat de câblage (110) correspondant aux DEL à semi-conducteur (150) au moyen de l'image capturée par la caméra.

10. Procédé selon la revendication 1, comprenant en outre :
après le transfert des DEL à semi-conducteur (150) vers le substrat de câblage (110), l'exécution d'un processus de câblage pour connecter électriquement le DEL à semi-conducteur d'éclairage (1501) au substrat de câblage (110).

11. Procédé selon la revendication 1, où le substrat d'assemblage (210) comprend :
un premier substrat d'assemblage assemblé avec un premier DEL à semi-conducteur prévu pour émettre une première lumière colorée lorsque le dispositif d'affichage est activé ; et
un deuxième substrat assemblé avec un deuxième DEL à semi-conducteur prévu pour émettre une deuxième lumière colorée différente de la première lumière colorée.

12. Dispositif d'affichage, comprenant :
un substrat de câblage (110) ; et
une pluralité de dispositifs électroluminescents à semi-conducteur, DEL (150), disposés sur le substrat de câblage (110),
où la pluralité de DEL à semi-conducteur (150) comprend un DEL à semi-conducteur d'éclairage (1501) et un DEL à semi-conducteur d'alignement (1502) ;
où :
le DEL à semi-conducteur d'éclairage (1501) et le DEL à semi-conducteur d'alignement (1502) ont la même forme et la même couleur d'émission lumineuse ;
le DEL à semi-conducteur d'éclairage (1501) est connecté électriquement à une électrode de câblage du substrat de câblage (110) et le DEL à semi-conducteur d'alignement (1502) n'est pas connecté électriquement à une électrode de câblage du substrat de câblage (110) ; et
une couche d'obscurcissement (183) à faible transmission lumineuse est disposée sur une surface supérieure du DEL à semi-conducteur d'alignement (1502), prévue pour empêcher la diffusion vers l'extérieur de la lumière générée par le DEL à semi-conducteur d'alignement (1502) ;
où le substrat de câblage (110) comprend :
un repère d'alignement (113) ayant une structure irrégulière,
où le DEL à semi-conducteur d'alignement (1502) est positionné de manière à recouvrir une marque d'alignement (111) du substrat de câblage (110).

13. Dispositif d'affichage selon la revendication 12, où :
le nombre de DEL à semi-conducteur d'éclairage (1501) pour chaque unité de surface du substrat de câblage (110) est au moins 100 fois supérieur au nombre de DEL à semi-conducteur d'alignement (1502) pour chaque unité de surface du substrat de câblage (110).
